# EUROPEAN PATENT APPLICATION

(11) **EP 4 794 461 A1**
(43) Date of publication of application: **19.08.2026**
(21) Application number: 24890240.5
(22) Date of filing: 20.08.2024
(51) Int. Cl.: H05K 7/20

(54) **EFFICIENT COOLING STRUCTURE FOR PLUG-IN MODULE**

(30) Priority: 17.11.2023 CN 202311554418; 13.08.2024 CN 202411119908
(71) Applicant: HUAWEI TECHNOLOGIES CO., LTD., Shenzhen 518129 (CN)
(72) Inventor: LIU, Qiang, Shenzhen, Guangdong 518129 (CN); JIAO, Zelong, Shenzhen, Guangdong 518129 (CN); HUANG, Huoqing, Shenzhen, Guangdong 518129 (CN); YAN, Tao, Shenzhen, Guangdong 518129 (CN)
(74) Representative: Gill Jennings & Every LLP
(86) International application number: PCT/CN2024/113424
(87) International publication number: WO 2025/102878

(57) **Abstract**

This application provides an efficient heat dissipation structure for an insertion module, and relates to the field of communication technologies. The heat dissipation structure provided in this application includes a frame component, an elastic fastener, and a heat dissipation substrate. The frame component includes a frame and a connector. The frame is configured to accommodate the insertion module. The connector is accommodated in the frame, and all signals of the connector are connected to an external signal through one connection end and a cable connected to the connection end. The heat dissipation substrate is configured to dissipate heat for the insertion module by coming into contact with a bottom surface of the frame and/or the insertion module. The elastic fastener is configured to press the insertion module, that is inserted into the frame, toward the bottom surface of the frame under elastic force. According to the heat dissipation structure provided in this application, an area of the heat dissipation substrate may be set to be large. In this way, the insertion module is pressed toward the bottom surface through the elastic fastener, so that a heat conduction path between the insertion module and the heat dissipation substrate is short. This helps improve heat dissipation efficiency of the heat dissipation substrate for the insertion module, and therefore the insertion module has good signal transmission performance.

## Description

### CROSS-REFERENCE TO RELATED APPLICATIONS

This application claims priorities to Chinese Patent Application No. 202311554418.2, filed with the China National Intellectual Property Administration on November 17, 2023 and entitled "EFFICIENT HEAT DISSIPATION STRUCTURE FOR INSERTION MODULE", and to Chinese Patent Application No. 202411119908.4, filed with the China National Intellectual Property Administration on August 13, 2024 and entitled "EFFICIENT HEAT DISSIPATION STRUCTURE FOR INSERTION MODULE", both of which are incorporated herein by reference in their entireties.

### TECHNICAL FIELD

This application relates to the field of communication technologies, and in particular, to an efficient heat dissipation structure for an insertion module.

### BACKGROUND

With upgrade and evolution of a communication network, both an amount and a transmission rate of communication data in the communication network are significantly increased. Correspondingly, power of various modular components in the communication network is also accordingly increased. Therefore, higher requirements are imposed on heat dissipation of the components. An optical module commonly used in the communication network is used as an example. As an important part of the communication network, the optical module is mainly configured to implement mutual conversion between optical and electrical signals. Therefore, to meet a signal transmission requirement of the communication network, the optical module needs to be expanded and upgraded. However, as signal transmission performance is improved, power consumption of the optical module is increasingly high, and consequently, the optical module generates more heat.

To ensure the signal transmission performance of the optical module, a heat dissipation structure is usually disposed for the optical module. However, in a current heat dissipation solution for the optical module, heat dissipation is usually performed on only one side of the optical module. For a high-power optical module, especially in a high-density layout scenario in which a plurality of optical modules are disposed in a belly to belly manner, it is difficult to meet a heat dissipation requirement of each optical module, thereby affecting signal transmission performance of the optical module. Based on this, how to improve heat dissipation efficiency of an optical module has become an urgent problem to be resolved by a person skilled in the art.

### SUMMARY

This application provides an efficient heat dissipation structure for an insertion module, to improve heat dissipation efficiency of the insertion module.

According to a first aspect, this application provides a heat dissipation structure for an insertion module. The heat dissipation structure may be configured to dissipate heat for an insertion module like an optical module or a hard disk. The heat dissipation structure includes a first frame component, a first elastic member, and a heat dissipation substrate. The first frame component includes a first frame and a first connector. The first frame is configured to accommodate a first insertion module. During specific disposition, the first frame includes a first top surface, a first bottom surface, and a first rear side surface. The first top surface and the first bottom surface are two oppositely disposed surfaces of the first frame, and the first rear side surface is located between the first top surface and the first bottom surface. The first connector is located in a cavity of the first frame close to the first rear side surface, the first connector includes a first connection end and a second connection end, the first connection end is electrically connected to the second connection end, the second connection end is configured to connect to a first cable, and all signals of the first connector are connected to an external signal through the second connection end and the first cable. In addition, the first insertion module includes a first signal end, and when the first signal end is not accurately aligned in a process of being inserted into the first connection end, the first signal end is configured to drive the first connector to float between the first top surface and the first bottom surface. The first elastic member is connected to the first top surface, and the first elastic member is configured to: after the first insertion module is inserted into the first frame, press the first insertion module toward the first bottom surface under elastic force. The heat dissipation substrate is located below the first bottom surface of the first frame, and the heat dissipation substrate is configured to dissipate heat for the first insertion module by coming into contact with the first bottom surface and/or the first insertion module. According to the heat dissipation structure provided in this application, the first insertion module is pressed toward the first bottom surface through the first elastic member, so that a heat conduction path between the first insertion module and the heat dissipation substrate is short. This helps improve heat dissipation efficiency of the heat dissipation substrate for the first insertion module. In addition, in the heat dissipation structure, all the signals of the first connector are connected to the external signal through the second connection end and the first cable. Therefore, no circuit board needs to be disposed on the first bottom surface of the first frame, so that more space is reserved for disposing the heat dissipation substrate. This helps increase a contact area between the first frame and the heat dissipation substrate, thereby improving heat dissipation efficiency of the heat dissipation substrate for the first insertion module accommodated in the first frame. In addition, because an area of the heat dissipation substrate of the heat dissipation structure provided in this application may be set to be large, it is possible that a plurality of frame components share one heat dissipation substrate. This is conducive to a miniaturization design of the heat dissipation structure including the plurality of frame components. In addition, one heat dissipation substrate can implement temperature equalization of a plurality of first insertion modules accommodated in the plurality of frame components. This helps improve heat dissipation efficiency of the plurality of first insertion modules.

In a possible implementation of this application, the heat dissipation structure further includes a first heat sink, the first heat sink is disposed on the first top surface, and the first top surface includes a first window. The first elastic member is further configured to implement a connection between the first heat sink and the first top surface. Specifically, the first elastic member is configured to: after the first insertion module is inserted into the first frame, press a portion that is of the first heat sink and that is opposite to the first window toward the first insertion module under elastic force, so that the first elastic member indirectly presses the first insertion module toward the first bottom surface through the portion that is of the first heat sink and that is opposite to the first window. By disposing the first heat sink in the first top surface, a heat dissipation path may be formed between the first insertion module accommodated in the first frame and the first heat sink, and another heat dissipation path may be formed between the first insertion module accommodated in the first frame and the heat dissipation substrate. Therefore, double-sided heat dissipation can be implemented for the first insertion module accommodated in the first frame. This helps improve heat dissipation efficiency of the first insertion module accommodated in the first frame.

In a possible implementation of this application, the first heat sink includes a first protrusion part, the first protrusion part is inserted into the first window, and at least a portion of the first protrusion part is located in the first frame. In this case, the first elastic member is configured to: after the first insertion module is inserted into the first frame, press the first protrusion part toward the first insertion module under elastic force. In this way, reliability of contact between the first heat sink and the first insertion module can be improved. This helps improve heat conduction efficiency between the first heat sink and the first insertion module, and improve heat dissipation efficiency of the first heat sink for the first insertion module.

In a possible implementation of this application, the first bottom surface includes a second window, the heat dissipation substrate includes a second protrusion part, the second protrusion part is inserted into the second window, and at least a portion of the second protrusion part is located in the first frame. In this way, a length of the heat dissipation path between the first insertion module accommodated in the first frame and the heat dissipation substrate can be shortened, thereby improving heat conduction efficiency between the heat dissipation substrate and the first insertion module, and improving heat dissipation efficiency of the heat dissipation substrate for the first insertion module.

In a possible implementation of this application, the first bottom surface is provided with a third protrusion part, the third protrusion part protrudes from the first bottom surface in a direction from the first bottom surface to the first top surface, and the third protrusion part is configured to come into contact with the first insertion module. In this way, efficiency of heat conduction from the first insertion module to the heat dissipation substrate can be improved by shortening the heat conduction path between the first insertion module accommodated in the first frame and the first bottom surface. This helps improve heat dissipation efficiency of the heat dissipation substrate for the first insertion module.

In addition, in a possible implementation of this application, the first bottom surface may be configured to directly come into contact with the first insertion module. In this way, the first insertion module accommodated in the first frame may be in contact with the first bottom surface. This can simplify a structure of the first frame, and can also make the heat conduction path between the first insertion module and the heat dissipation substrate short, thereby improving heat dissipation efficiency of the heat dissipation substrate for the first insertion module.

In a possible implementation of this application, an opening of the first connection end includes a first guiding surface and a second guiding surface that are disposed opposite to each other, the first guiding surface is closer to the first top surface than the second guiding surface, and a spacing between the first guiding surface and the second guiding surface gradually increases in a direction away from the first rear side surface. In this way, the first connection end may have the opening that expands outward, so that in a process of inserting the first insertion module into the first frame, the first guiding surface and the second guiding surface play a role of guiding insertion of a signal end of the first insertion module and the first connection end of the first connector. This can help improve insertion efficiency of the first insertion module and the heat dissipation structure.

In a possible implementation of this application, the first frame further includes a first stop part, the first stop part is located in the first frame, the first stop part is connected to at least one of the first top surface and the first bottom surface, and the first stop part is configured to limit movement of the first connector in the direction away from the first rear side surface. In this way, in a process of removing the first insertion module accommodated in the first frame, the first connector can be effectively prevented from falling off from the first frame with the first insertion module. This helps improve structural reliability of the heat dissipation structure. In addition, in the process of inserting the first insertion module into the first frame, the first stop part may further play a role of stopping the first insertion module, to reduce a risk that the signal end of the first insertion module or the first connection end is damaged due to excessively large insertion force applied to the first insertion module.

In a possible implementation of this application, the heat dissipation structure further includes a second frame component and a second elastic member. The second frame component includes a second frame and a second connector. The second frame is configured to accommodate a second insertion module. The second frame includes a second top surface, a second bottom surface, and a second rear side surface. The second top surface and the second bottom surface are two oppositely disposed surfaces of the second frame, and the second rear side surface is located between the second top surface and the second bottom surface. The second connector is located in a cavity of the second frame close to the second rear side surface, the second connector includes a third connection end and a fourth connection end, the fourth connection end is configured to connect to a second cable, and all signals of the second connector are connected to an external signal through the fourth connection end and the second cable. In addition, the second insertion module includes a second signal end, and when the second signal end is not accurately aligned in a process of being inserted into the third connection end, the second signal end is configured to drive the second connector to float between the second top surface and the second bottom surface. The first elastic member is connected to the second top surface, and the second elastic member is configured to: after the second insertion module is inserted into the second frame, press the second insertion module toward the second bottom surface under elastic force. The heat dissipation substrate is located between the first frame component and the second frame component, and the heat dissipation substrate is located below the second bottom surface, and is configured to dissipate heat for the second insertion module by coming into contact with the second bottom surface and/or the second insertion module.

According to the heat dissipation structure provided in this application, such a design can effectively improve layout density of frame components of the heat dissipation structure, so that more insertion modules can be inserted into a communication device in which the heat dissipation structure is used, to meet communication performance of the communication device. In addition, in the heat dissipation structure, the first insertion module is pressed toward the first bottom surface through the first elastic member, and the second insertion module is pressed toward the second bottom surface through the second elastic member, so that a heat conduction path between the first insertion module and the heat dissipation substrate and a heat conduction path between the second insertion module and the heat dissipation substrate are short. This helps improve heat dissipation efficiency of the heat dissipation substrate for the first insertion module. In addition, because the first frame component and the second frame component share a same heat dissipation substrate, the same heat dissipation substrate may be used to simultaneously dissipate heat for the first insertion module in the first frame component and the second insertion module in the second frame component that are disposed on two sides of the heat dissipation substrate. This helps implement temperature equalization of the heat dissipation substrate for each insertion module, thereby improving heat dissipation efficiency of the heat dissipation substrate for each insertion module. In addition, all the signals of the second connector are connected to the external signal through the fourth connection end and the second cable. Therefore, no circuit board needs to be disposed on the second bottom surface of the second frame, so that more space is reserved for disposing the heat dissipation substrate. This helps increase a contact area between the second frame and the heat dissipation substrate, thereby improving heat dissipation efficiency of the heat dissipation substrate for the second insertion module accommodated in the second frame.

In a possible implementation of this application, the heat dissipation structure further includes a second heat sink, the second heat sink is disposed on the second top surface, and the second top surface includes a third window. The second elastic member is configured to implement a connection between the second heat sink and the second top surface. The second elastic member is configured to: after the second insertion module is inserted into the second frame, press a portion that is of the second heat sink and that is opposite to the second window toward the second insertion module under elastic force, so that the second elastic member indirectly presses the second insertion module toward the second bottom surface through the portion that is of the second heat sink and that is opposite to the third window. By disposing the second heat sink on the second top surface, a heat dissipation path may be formed between the second insertion module accommodated in the second frame and the second heat sink, and another heat dissipation path may be formed between the second insertion module accommodated in the second frame and the heat dissipation substrate. Therefore, double-sided heat dissipation can be implemented for the second insertion module accommodated in the second frame. This helps improve heat dissipation efficiency of the second insertion module accommodated in the second frame.

In a possible implementation of this application, the second heat sink includes a fourth protrusion part, the fourth protrusion part is inserted into the third window, and a portion of the fourth protrusion part is located in the second frame. In this case, the second elastic member is configured to: after the second insertion module is inserted into the second frame, press the fourth protrusion part toward the second insertion module under elastic force. In this way, reliability of contact between the second heat sink and the second insertion module can be improved.

In a possible implementation of this application, the second bottom surface includes a fourth window, the heat dissipation substrate includes a fifth protrusion part, the fifth protrusion part is inserted into the fourth window, at least a portion of the fifth protrusion part is located in the second frame, and the fifth protrusion part is configured to come into contact with the second insertion module. In this way, a length of the heat dissipation path between the second insertion module accommodated in the second frame and the heat dissipation substrate can be shortened, thereby improving heat conduction efficiency between the heat dissipation substrate and the second insertion module, and improving heat dissipation efficiency of the heat dissipation substrate for the second insertion module.

In a possible implementation of this application, the second bottom surface is provided with a sixth protrusion part, the sixth protrusion part protrudes from the second bottom surface in a direction from the second bottom surface to the second top surface, and the sixth protrusion part is configured to come into contact with the second insertion module. In this way, efficiency of heat conduction from the second insertion module to the heat dissipation substrate can be improved by shortening the heat conduction path between the second insertion module accommodated in the second frame and the second bottom surface. This helps improve heat dissipation efficiency of the heat dissipation substrate for the second insertion module.

In addition, in a possible implementation of this application, the second bottom surface may be further configured to directly come into contact with the second insertion module. In this way, the second insertion module accommodated in the second frame may be in contact with the second bottom surface. This can simplify a structure of the second frame, and can also make the heat conduction path between the second insertion module and the heat dissipation substrate short, thereby improving heat dissipation efficiency of the heat dissipation substrate for the second insertion module.

In a possible implementation of this application, an opening of the third connection end includes a third guiding surface and a fourth guiding surface that are disposed opposite to each other, the third guiding surface is closer to the second top surface than the fourth guiding surface, and a spacing between the third guiding surface and the fourth guiding surface gradually increases in a direction away from the second rear side surface. In this way, the third connection end may have the opening that expands outward, so that in a process of inserting the second insertion module into the second frame, the third guiding surface and the fourth guiding surface play a role of guiding insertion of a signal end of the second insertion module into the third connection end of the second connector. This can help improve insertion efficiency of the second insertion module into the heat dissipation structure.

In a possible implementation of this application, the second frame further includes a second stop part, the second stop part is located in the second frame, the second stop part is connected to at least one of the second top surface and the second bottom surface, and the second stop part is configured to limit movement of the second connector in the direction away from the second rear side surface. In this way, in a process of removing the second insertion module from the second frame, the second connector can be effectively prevented from falling off from the second frame with the second insertion module. This helps improves structural reliability of the heat dissipation structure. In addition, in the process of inserting the second insertion module into the second frame, the second stop part may further play a role of stopping the second insertion module, to reduce a risk that the signal end of the second insertion module or the second connection end is damaged due to excessively large insertion force applied to the second insertion module.

In a possible implementation of this application, the heat dissipation structure includes a plurality of first frame components, a plurality of first heat sinks, and a plurality of first elastic members. The plurality of first frame components are sequentially arranged in a first direction, the first direction is perpendicular to a direction from the first top surface to the first bottom surface, and the first direction is parallel to the first rear side surface. Each first heat sink is connected to a first top surface of one first frame under elastic force of one first elastic member, and a first protrusion part of each first heat sink is inserted into a first window of a corresponding first frame. In addition, a first bottom surface of each first frame is in contact with a first heat dissipation surface of a same heat dissipation substrate. In this design manner of the heat dissipation structure, the plurality of first frame components share the same heat dissipation substrate for heat dissipation, so that the heat dissipation substrate can implement a temperature equalization effect on the plurality of first frame components. This helps improve heat dissipation performance of the heat dissipation structure.

In the foregoing implementation, two adjacent first frame components in the plurality of first frame components may be spaced from each other, so that mutual impact between the first frame components can be effectively reduced, to ensure heat dissipation performance of each first frame component.

In a possible implementation of this application, when the heat dissipation structure includes the plurality of first frame components sequentially arranged in the first direction, the heat dissipation structure may include at least one first heat sink and at least one first elastic member, so that at least two first frame components share one first heat sink. Specifically, one first heat sink is pressed toward a first top surface of each first frame of at least two adjacent first frame components under elastic force of one first elastic member, and one first protrusion part corresponding to a first window of each first frame of the at least two adjacent first frame components is disposed on the one first heat sink. In addition, in this design manner, a first bottom surface of each first frame is also in contact with the first heat dissipation surface of the heat dissipation substrate. In this design manner of the heat dissipation structure, the plurality of first frame components share the same heat dissipation substrate for heat dissipation, so that the heat dissipation substrate can implement temperature equalization on the plurality of first frame components. In addition, at least two first frame components may share one first heat sink, so that the one first heat sink can implement temperature equalization on the at least two first frame components. This can effectively improve heat dissipation performance of the heat dissipation structure, and simplify a structure of the heat dissipation structure.

In a possible implementation of this application, a plurality of first frames of the plurality of first frame components are of an integrated structure, or two first frames of two adjacent first frame components are attached to each other. This helps increase a quantity of first frame components disposed on the first heat dissipation surface of the heat dissipation substrate, thereby increasing a quantity of first insertion modules that can be inserted into the communication device in which the heat dissipation structure is used, and improving communication performance of the communication device.

In a possible implementation of this application, the heat dissipation structure includes a plurality of second frame components, a plurality of second heat sinks, and a plurality of second elastic members, and the plurality of second frame components are sequentially arranged in the first direction. Each second heat sink is connected to a second top surface of one second frame component under elastic force of one second elastic member, and a second protrusion part of each second heat sink is inserted into a second window of a corresponding second frame component. In addition, a second bottom surface of each second frame is in contact with a second heat dissipation surface of a same heat dissipation substrate. In this design manner of the heat dissipation structure, the plurality of second frame components share the same heat dissipation substrate for heat dissipation, so that the heat dissipation substrate can implement a temperature equalization effect on the plurality of second frame components. This helps improve heat dissipation performance of the heat dissipation structure.

In the foregoing implementation, two adjacent second frame components in the plurality of second frame components may be spaced from each other, so that mutual impact between the second frame components can be effectively reduced, to ensure heat dissipation performance of each second frame component.

In a possible implementation of this application, when the heat dissipation structure includes the plurality of second frame components sequentially arranged in the first direction, the heat dissipation structure may include at least one second heat sink and at least one second elastic member, so that at least two second frame components share one second heat sink. Specifically, one second heat sink is pressed toward a second top surface of each second frame of at least two adjacent second frame components under elastic force of one second elastic member, and one second protrusion part corresponding to a second window of each second frame of the at least two adjacent second frame components is disposed on the one second heat sink. In addition, in this design manner, a second bottom surface of each second frame is also in contact with the second heat dissipation surface of the heat dissipation substrate. In this design manner of the heat dissipation structure, the plurality of second frame components share the same heat dissipation substrate for heat dissipation, so that the heat dissipation substrate can implement temperature equalization on the plurality of second frame components. In addition, at least two second frame components can share one second heat sink, so that the one second heat sink implement temperature equalization on the at least two second frame components. This can effectively improve heat dissipation performance of the heat dissipation structure, and further simplify a structure of the heat dissipation structure.

In a possible implementation of this application, the plurality of second frames of the plurality of second frame components are of an integrated structure, or two second frames of two adjacent second frame components are attached to each other. This helps increase a quantity of second frame components disposed on the second heat dissipation surface of the heat dissipation substrate, thereby increasing a quantity of second insertion modules that can be inserted into the communication device in which the heat dissipation structure is used, and improving communication performance of the communication device.

When the heat dissipation structure provided in this application includes a plurality of first frame components and a plurality of second frame components, the plurality of first frame components and the plurality of second frame components may be disposed in a one-to-one correspondence. In this way, disposing density of the frame components of the heat dissipation structure may be increased. This is conducive to a miniaturization design of the heat dissipation structure, and helps increase a quantity of first insertion modules that can be inserted into the communication device in which the heat dissipation structure is used, thereby helping improve communication performance of the communication device.

In a possible implementation of this application, a surface that is of the first heat sink and that is away from the heat dissipation substrate further includes a first heat dissipation fin, and the first heat dissipation fin extends in the direction from the first bottom surface to the first top surface. In this way, a heat dissipation area of the first heat sink can be effectively increased, thereby improving heat dissipation performance of the first heat sink.

Similarly, a surface that is of the second heat sink and that is away from the heat dissipation substrate further includes a second heat dissipation fin, and the second heat dissipation fin extends in a direction from the second bottom surface to the second top surface, to increase a heat dissipation area of the second heat sink, so as to improve heat dissipation performance of the second heat sink.

In a possible implementation of this application, the first heat dissipation surface of the heat dissipation substrate further includes a third heat dissipation fin, the third heat dissipation fin is located on a peripheral side of the first frame component, and the third heat dissipation fin extends in a direction from the second heat dissipation surface to the first heat dissipation surface. In this way, a heat dissipation area of the heat dissipation substrate can be increased, thereby improving heat dissipation performance of the heat dissipation substrate.

In addition, the second heat dissipation surface of the heat dissipation substrate further includes a fourth heat dissipation fin, the fourth heat dissipation fin is located on a peripheral side of the second frame component, and the fourth heat dissipation fin extends in a direction from the first heat dissipation surface to the second heat dissipation surface. In this way, the heat dissipation area of the heat dissipation substrate is further increased, thereby improving heat dissipation performance of the heat dissipation substrate.

In a possible implementation of this application, the heat dissipation substrate may be a liquid cooling plate. In this way, the heat dissipation substrate may have a good temperature equalization property, thereby helping improve a temperature equalization effect of the heat dissipation substrate on each frame component, and improving heat dissipation performance of the heat dissipation structure.

In another possible implementation of this application, the heat dissipation substrate includes a first substrate, a second substrate, and a fifth heat dissipation fin, the first substrate and the second substrate are disposed opposite to each other, and the fifth heat dissipation fin is located between the first substrate and the second substrate. The heat dissipation substrate is located between the first frame component and the second frame component, the first substrate is located below the first bottom surface of the first frame, and is configured to dissipate heat for the first insertion module by coming into contact with the first bottom surface and/or the first insertion module. The second substrate is located below the second bottom surface of the second frame, and is configured to dissipate heat for the second insertion module by coming into contact with the second bottom surface and/or the second insertion module. Because the heat dissipation substrate has a large heat dissipation area, the heat dissipation substrate is conducive to improving a temperature equalization effect of the heat dissipation substrate on each frame component, thereby improving heat dissipation performance of the heat dissipation structure.

According to a second aspect, this application further provides an efficient heat dissipation structure for an insertion module. The heat dissipation structure includes a first frame component, a first heat sink, a first elastic member, and a fastening substrate. The first frame component includes a first frame and a first connector. The first frame is configured to accommodate a first insertion module. The first frame includes a first top surface, a first bottom surface, and a first rear side surface. The first top surface and the first bottom surface are disposed opposite to each other, and the first rear side surface is located between the first top surface and the first bottom surface. The first heat sink is disposed on the first top surface. The fastening substrate is located below the first bottom surface, and is configured to support the first frame component. The first connector is located in a cavity of the first frame close to the first rear side surface, the first connector includes a first connection end and a second connection end, the first connection end is electrically connected to the second connection end, the second connection end is configured to connect to a first cable, and all signals of the first connector are connected to an external signal through the second connection end and the first cable. The first insertion module includes a first signal end, and when the first signal end is not accurately aligned in a process of being inserted into the first connection end, the first signal end is configured to drive the first connector to float between the first top surface and the first bottom surface. The first elastic member is connected to the first bottom surface, and the first elastic member is configured to: after the first insertion module is inserted into the first frame, press the first insertion module toward the first top surface under elastic force. According to the heat dissipation structure provided in this application, the first insertion module is pressed toward the first top surface through the first elastic member, so that a heat conduction path between the first insertion module and the heat dissipation substrate is short. This helps improve heat dissipation efficiency of the heat dissipation substrate for the first insertion module. In addition, because in the heat dissipation structure, all the signals of the first connector are connected to the external signal through the second connection end and the first cable, a circuit board does not need to be disposed on the first bottom surface of the first frame, so that more space is reserved for disposing the fastening substrate. In this way, it is possible for a plurality of frame components to share one fastening substrate. This is conducive to a miniaturization design of the heat dissipation structure including the plurality of frame components.

In a possible implementation of this application, the heat dissipation structure further includes a second frame component, a second heat sink, and a second elastic member, and the second frame component includes a second frame and a second connector. The second frame is configured to accommodate a second insertion module. The second frame includes a second top surface, a second bottom surface, and a second rear side surface. The second top surface and the second bottom surface are disposed opposite to each other, and the second rear side surface is located between the second top surface and the second bottom surface. The second heat sink is disposed on the second top surface. The fastening substrate is located below the second bottom surface, and is configured to support the second frame component. The second connector is located in a cavity of the second frame close to the second rear side surface, the second connector includes a third connection end and a fourth connection end, the third connection end is electrically connected to the fourth connection end, the fourth connection end is configured to connect to a second cable, and all signals of the second connector are connected to an external signal through the fourth connection end and the second cable. The second insertion module includes a second signal end, and when the second signal end is not accurately aligned in a process of being inserted into the third connection end, the second signal end is configured to drive the second connector to float between the second top surface and the second bottom surface. The second elastic member is connected to the second bottom surface, and the second elastic member is configured to: after the second insertion module is inserted into the second frame, press the second insertion module toward the second top surface under elastic force. According to the heat dissipation structure provided in this application, such a design can effectively improve layout density of frame components of the heat dissipation structure, so that more insertion modules can be inserted into a communication device in which the heat dissipation structure is used, to meet communication performance of the communication device.

According to a third aspect, this application further provides a communication device. The communication device includes a first insertion module and the heat dissipation structure according to the first aspect or the second aspect, and the first insertion module is accommodated in the first frame. The heat dissipation structure of the communication device provided in this application can efficiently dissipate heat for the first insertion module, so that the first insertion module may have good signal transmission performance. This helps improve running reliability of the communication device.

### BRIEF DESCRIPTION OF DRAWINGS

FIG. 1a is a side view of a heat dissipation structure according to an embodiment of this application;
FIG. 1b is a side view of another structure of a heat dissipation structure according to an embodiment of this application;
FIG. 2 is a diagram of a structure of a process of inserting a first insertion module into a first frame component according to an embodiment of this application;
FIG. 3 is a diagram of a structure of a first connector according to an embodiment of this application;
FIG. 4 is a diagram of another structure of a process of inserting a first insertion module into a first frame component according to an embodiment of this application;
FIG. 5 is a diagram of another structure of a process of inserting a first insertion module into a first frame component according to an embodiment of this application;
FIG. 6 is a diagram of a structure of a process of removing a first insertion module from a first frame according to an embodiment of this application;
FIG. 7 is a diagram of a structure of a communication device according to an embodiment of this application;
FIG. 8 is a diagram of another structure of a communication device according to an embodiment of this application;
FIG. 9 is a diagram of another structure of a communication device according to an embodiment of this application;
FIG. 10 is a diagram of another structure of a communication device according to an embodiment of this application;
FIG. 11 is a diagram of another structure of a communication device according to an embodiment of this application;
FIG. 12 is a diagram of another structure of a communication device according to an embodiment of this application;
FIG. 13 is a diagram of another structure of a communication device according to an embodiment of this application;
FIG. 14 is a diagram of another structure of a communication device according to an embodiment of this application;
FIG. 15 is a diagram of another structure of a communication device according to an embodiment of this application;
FIG. 16a is a diagram of another structure of a communication device according to an embodiment of this application;
FIG. 16b is a diagram of another structure of a communication device according to an embodiment of this application;
FIG. 16c is a diagram of another structure of a communication device according to an embodiment of this application;
FIG. 17a is a diagram of another structure of a communication device according to an embodiment of this application;
FIG. 17b is a diagram of another structure of a communication device according to an embodiment of this application;
FIG. 17c is a diagram of another structure of a communication device according to an embodiment of this application; and
FIG. 17d is a diagram of another structure of a communication device according to an embodiment of this application.

Reference numerals:
100: heat dissipation structure; 1: first frame component; 101: first frame; 1011: first top surface; 10111: first window;
10112: seventh protrusion part; 1012: first bottom surface; 10121: second window; 10122: third protrusion part; 1013: first rear side surface;
1014: first stop part; 102: first connector; 1021: first connection end; 10211: first guiding surface; 10212: second guiding surface;
10213: fitting part; 1022: second connection end; 2: first heat sink; 201: first protrusion part; 202: first heat dissipation fin;
3: first elastic member; 4: heat dissipation substrate; 4a: first heat dissipation surface; 4b: second heat dissipation surface; 401: second protrusion part; 402: third heat dissipation fin;
403: fifth protrusion part; 404: fourth heat dissipation fin; 405: first substrate; 406: second substrate; 407: fifth heat dissipation fin;
5: first cable; 6: second frame component; 601: second frame; 6011: second top surface; 60111: third window;
60112: eighth protrusion part; 6012: second bottom surface; 60121: fourth window; 60122: sixth protrusion part; 6013: second rear side surface;
6014: second stop part; 602: second connector; 6021: third connection end; 60211: third guiding surface; 60212: fourth guiding surface;
6022: fourth connection end; 7: second heat sink; 701: fourth protrusion part; 702: second heat dissipation fin; 8: second elastic member;
9: second cable; 10: fastening substrate; 1001: first support surface; 1002: second support surface;
200: first insertion module; 2001: first signal end; 2002: heat source of the first insertion module;
300: second insertion module; 3001: second signal end; and 3002: heat source of the second insertion module.

### DESCRIPTION OF EMBODIMENTS

To make the objectives, technical solutions, and advantages of this application clearer, the following further describes this application in detail with reference to the accompanying drawings. However, example implementations may be implemented in a plurality of forms, and are not to be construed as being limited to implementations described herein. Identical reference numerals in the accompanying drawings denote identical or similar structures. Therefore, repeated description thereof is omitted. Expressions of positions and directions in embodiments of this application are described by using the accompanying drawings as examples. However, changes may also be made as required, and all the changes fall within the protection scope of this application. The accompanying drawings in embodiments of this application are merely used to illustrate relative position relationships and do not represent an actual scale.

It should be noted that specific details are set forth in the following descriptions for ease of understanding this application. However, this application can be implemented in a plurality of manners different from those described herein, and a person skilled in the art can perform similar promotion without departing from the connotation of this application. Therefore, this application is not limited to the following disclosed specific embodiments.

To facilitate understanding of a heat dissipation structure provided in this application, the following first describes an application scenario of the heat dissipation structure. In this application, a specific type of a communication device in which the heat dissipation structure is used is not limited. For example, the communication device may be a network communication device like a router or a switch, or may be a compute device like a server. Currently, components used in the communication device to implement a communication function of the communication device are mostly modular components, and are mostly insertion modules, for example, an optical module of the network communication device or a hard disk in the compute device, so that a signal transmission requirement of the communication device can be met through insertion and removal or replacement of the insertion modules.

As an amount and a rate of communication data in the communication device continuously increase, to meet the signal transmission requirement of the communication device, various modular components in the communication device need to be expanded and upgraded. However, as signal transmission performance improves, power consumption of the modular component is increasingly high, and consequently, the modular component generates more heat. If heat generated by the modular component cannot be discharged in a timely manner, signal transmission performance of the modular component is affected, and in a severe case, the modular component may be damaged. To enable the modular component to operate within a temperature range that meets a communication requirement, a heat dissipation structure is usually disposed for the modular component in the communication device. However, limited by layout space, the heat dissipation structure can form a heat dissipation path on only one side of the modular component. This makes it difficult to discharge, in a timely manner, heat of a high-power modular component that generates much heat.

In view of this, the heat dissipation structure provided in embodiments of this application can form a heat dissipation path on each of two surfaces of the modular component, to improve heat dissipation efficiency of the modular component by performing double-sided heat dissipation on the modular component, so as to improve the signal transmission performance of the modular component, and improve running stability of the communication device in which the modular component is used. To facilitate understanding of the technical solutions of this application, the following specifically describes the heat dissipation structure provided in this application with reference to the accompanying drawings and specific implementations.

The heat dissipation structure provided in this application is designed based on a frame that is in the communication device and that is configured to accommodate the modular component. In different communication devices, structures of frames configured to accommodate modular components are similar. Therefore, to facilitate understanding of the heat dissipation structure provided in this application, the following mainly describes the heat dissipation structure provided in this application in detail by using an example in which the communication device is a network communication device and the modular component is an insertion module like an optical module.

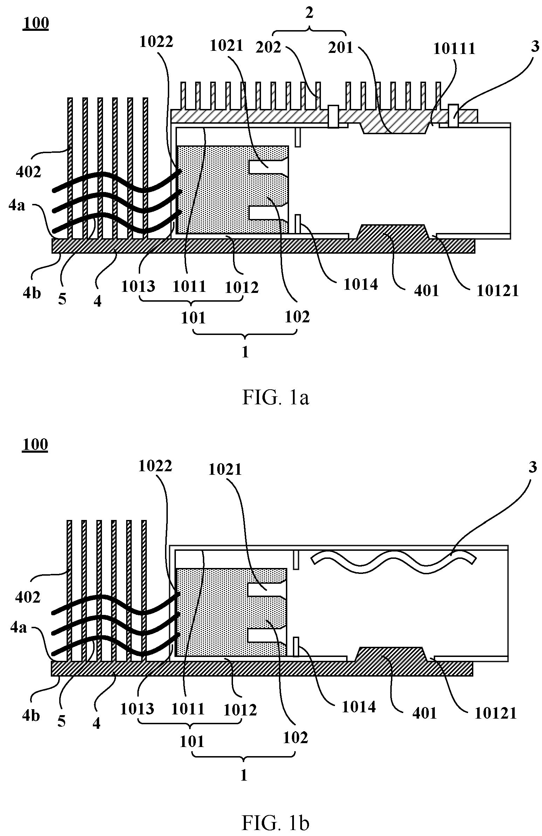

FIG. 1a is a side view of a heat dissipation structure 100 according to an embodiment of this application. The heat dissipation structure 100 includes a first frame component 1, a first heat sink 2, a first elastic member 3, and a heat dissipation substrate 4. The first frame component 1 includes a first frame 101 and a first connector 102. The first frame 101 may be configured to accommodate a first insertion module. The first frame 101 includes a first top surface 1011, a first bottom surface 1012, and a first rear side surface 1013. The first top surface 1011 and the first bottom surface 1012 are disposed opposite to each other, and the first rear side surface 1013 is located between the first top surface 1011 and the first bottom surface 1012. It may be understood that the first frame 101 may be in a shape of a cuboid, to form six surfaces, or may be in a shape of another cube similar to the cuboid. This is not limited in this application.

It should be noted that, in this application, both the "top" and the "bottom" of the first frame 101 are based on the heat dissipation substrate 4. To be specific, a side that is of the first frame 101 and that is away from the heat dissipation substrate 4 is the "top", and a side that is of the first frame 101 and that is close to the heat dissipation substrate 4 is the "bottom". In addition, the "rear" of the first frame 101 is a side opposite to an insertion port of the first frame 101. In this application, each "surface" (for example, the first top surface 1011, the first bottom surface 1012, or the first rear side surface 1013) formed by the first frame 101 may be a closed surface or a surface with a window. For example, in an embodiment, the first rear side surface 1013 may be disposed as a surface with a window, so that the first connector 102 can be connected to a cable through the window in the first rear side surface 1013. The first top surface 1011 may be disposed as a surface with a window, so that the first heat sink 2 can be, through the window, in better contact with the first insertion module inserted into the first frame 101. In addition, the first bottom surface 1012 may be disposed as a closed surface or a surface with a window, to adapt to different shapes of the heat dissipation substrate 4. It should be noted that the foregoing is merely some examples. In actual application, a person skilled in the art may select, based on the foregoing examples and in combination with an actual application scenario, to dispose one or more surfaces as closed surfaces or surfaces with windows. This is not limited in this application.

Still refer to FIG. 1a. The first connector 102 is located in a cavity of the first frame 101 close to the first rear side surface 1013. When the first frame component 1 is in a state shown in FIG. 1a, the first connector 102 is in contact with the first bottom surface 1012, and there is a specific gap between the first connector 102 and the first top surface 1011. The first connector 102 may be configured to electrically connect to another communication module in a communication device. During specific implementation, the first connector 102 includes a first connection end 1021 and a second connection end 1022, and the first connection end 1021 is electrically connected to the second connection end 1022 (for example, through a line inside the first connector 102). The first connection end 1021 may be configured to be inserted into the first insertion module. The second connection end 1022 may be configured to implement an electrical connection between the first connector 102 and another module in the communication device. In this application, the second connection end 1022 is connected to a first cable 5, so that all signals of the first connector 102 are connected to an external signal through the second connection end 1022 and the first cable 5. The external signal herein is a signal of another module (for example, a server board mounted with a processor) located outside the heat dissipation structure 100, or more specifically, a signal of another module located outside the first frame 101.

In this application, the first cable 5 may be a conducting wire, or may be another flexible dielectric like a flexible circuit board. One end of the first cable 5 is connected to the second connection end 1022 through an interface, and the other end of the first cable 5 is connected to another module through another interface, so that the first connector 102 is flexibly connected to the another module in the communication device.

Still refer to FIG. 1a. The first frame 101 further includes a first stop part 1014. The first stop part 1014 is located in the first frame 101, and the first stop part 1014 is connected to at least one of the first top surface 1011 and the first bottom surface 1012. In addition, a projection of the first stop part 1014 on the first rear side surface 1013 partially overlaps a projection of the first connector 102 on the first rear side surface 1013, so that the first stop part 1014 can be configured to limit movement of the first connector 102 in a direction away from the first rear side surface 1013.

It may be understood that, while the first stop part 1014 limits the first connector 102, the first stop part 1014 further needs to avoid at least a portion of an opening of the first connection end 1021 of the first connector 102. To be specific, in a process of inserting the first insertion module into the first frame 101, the opening of the first connection end 1021 is not completely blocked by the first stop part 1014. In this application, a specific manner of disposing the first stop part 1014 is not limited. For example, the first stop part 1014 may be of an annular structure, and the first stop part 1014 may be connected to both the first top surface 1011 and the first bottom surface 1012. This helps improve structural reliability of the first stop part 1014. Alternatively, the first stop part 1014 may include two parts that are disposed opposite to each other and are spaced from each other, where one part is connected to the first top surface 1011, and the other part is connected to the first bottom surface 1012.

In the heat dissipation structure 100 provided in this embodiment of this application, the first heat sink 2 is disposed on the first top surface 1011 of the first frame 101. In addition, as shown in FIG. 1a, the first top surface 1011 of the first frame 101 includes a first window 10111, the first heat sink 2 includes a first protrusion part 201, the first protrusion part 201 is inserted into the first window 10111, and a portion of the first protrusion part 201 is located in the first frame 101.

A shape of the first protrusion part 201 is not limited in this application. For example, the first protrusion part 201 may be in a shape of a trapezoid shown in FIG. 1a, or may be in a shape of a rectangle or in another possible shape.

In this application, the first heat sink 2 may be connected to the first top surface 1011 through the first elastic member 3. During specific implementation, the first elastic member 3 is connected to the first top surface 1011. In this case, the first elastic member 3 may press the first heat sink 2 and the first top surface 1011 tightly under elastic force, so that the first elastic member 3 may be configured to: after the first insertion module is inserted into the first frame 101, always press the first protrusion part 201 toward the first insertion module under elastic force. In this way, the first elastic member 3 indirectly presses the first insertion module toward the first bottom surface 1012 under elastic force through the first protrusion part 201 of the first heat sink 2.

It should be noted that, in some possible embodiments of this application, a surface that is of the first heat sink 2 and that faces the first frame 101 may be a plane, and a protrusion is disposed on a surface that is of the first insertion module and that faces the first heat sink 2. The protrusion of the first insertion module may be inserted into the first window 10111 of the first top surface 1011. In this way, a portion that is of the first heat sink 2 and that is opposite to the first window 10111 may be pressed toward the first insertion module under elastic force of the first elastic member 3, so that the portion of the first heat sink 2 is in contact with the first insertion module, thereby implementing heat dissipation of the first heat sink 2 for the first insertion module.

A specific type of the first elastic member 3 is not limited in this application. For example, the first elastic member 3 may be an elastic fastener. The elastic fastener may include two connection parts disposed opposite to each other and a fastening part connected between the two connection parts. When the two connection parts of the elastic fastener are connected to the first top surface 1011, the fastening part may press the first heat sink 2 toward the first top surface 1011. Alternatively, the first elastic member 3 may be an elastic screw or an elastic fastener in another form. Details are not described herein one by one. In addition, in embodiments of this application, the first elastic member 3 may be of an integrated structure, or may include a plurality of components, where the plurality of components may be connected or not connected to each other. This is not limited in this application. In addition, the first elastic member 3 may be disposed outside the first frame 101, or may be accommodated in the first frame 101, provided that the first elastic member 3 can apply squeezing force toward the first bottom surface 1012 to the first insertion module accommodated in the first frame 101.

Still refer to FIG. 1a. The heat dissipation substrate 4 is located below the first bottom surface 1012 of the first frame 101. In this application, below the first bottom surface 1012 means on a side that is of the first bottom surface 1012 and that is away from the first top surface 1011.

In this embodiment of this application, the heat dissipation substrate 4 is configured to dissipate heat for the first insertion module by coming into contact with the first bottom surface 1012 and/or the first insertion module accommodated in the first frame 101. During specific implementation, the heat dissipation substrate 4 includes a first heat dissipation surface 4a and a second heat dissipation surface 4b, and the first heat dissipation surface 4a and the second heat dissipation surface 4b are disposed opposite to each other. At least a portion of the first bottom surface 1012 of the first frame 101 is in contact with the first heat dissipation surface 4a. In this application, the first bottom surface 1012 of the first frame 101 may be further fastened to the heat dissipation substrate 4, and a connection manner may be, but is not limited to, welding, bonding, riveting, threaded connection, or the like, to improve connection reliability between the first frame 101 and the heat dissipation substrate 4. In addition, in the heat dissipation structure 100, the first heat sink 2 is elastically connected to the first frame 101 through the first elastic member 3, and the first frame 101 does not need to be connected to the heat dissipation substrate 4 through an elastic fastener. This helps reduce operation space occupied by the heat dissipation structure 100 in the communication device, thereby facilitating disposing the heat dissipation structure 100 in the communication device.

To improve heat dissipation efficiency of the heat dissipation substrate 4 for the first insertion module, as shown in FIG. 1a, the first bottom surface 1012 includes a second window 10121, and the heat dissipation substrate 4 includes a second protrusion part 401. In this case, the second protrusion part 401 is inserted into the second window 10121, and at least a portion of the second protrusion part 401 is located in the first frame 101. The second protrusion part 401 may be configured to come into contact with the first insertion module accommodated in the first frame 101. A shape of the second protrusion part 401 is not limited in this application. For example, the second protrusion part 401 may be a trapezoid shown in FIG. 1a, or may be a rectangle or in another possible shape.

It should be noted that, in the heat dissipation structure 100 shown in FIG. 1a, the heat dissipation substrate 4 is in direct contact with the first bottom surface 1012, and the heat dissipation substrate 4 may be in direct contact with the first insertion module accommodated in the first frame 101 through the second protrusion part 401. However, in another possible embodiment of this application, the heat dissipation substrate 4 may not be in contact with the first bottom surface 1012. In addition, in the heat dissipation structure 100 shown in FIG. 1a, there is no necessary relationship between disposing positions of the first protrusion part 201 and the second protrusion part 401, and the disposing positions may be specifically set based on a specific heat dissipation requirement and the like.

In addition, in this application, a type of the first heat sink 2 is not limited. For example, the first heat sink 2 may be a vapor chamber (vapor chamber, VC), a liquid cooling plate, or of another high thermal conductivity material structure. The heat dissipation substrate 4 may also be a VC, a liquid cooling plate, or of another high thermal conductivity material structure. In addition, the first heat sink 2 and the heat dissipation substrate 4 may be of a same type or different types.

As shown in FIG. 1a, the first heat sink 2 further includes a first heat dissipation fin 202, and the first heat dissipation fin 202 extends in a direction from the first bottom surface 1012 to the first top surface 1011. This helps increase a heat dissipation area of the first heat sink 2, thereby improving heat dissipation performance of the first heat sink 2. In addition, the heat dissipation substrate 4 further includes a third heat dissipation fin 402. The third heat dissipation fin 402 is located on a peripheral side of the first frame component 1, and the third heat dissipation fin 402 extends in a direction from the second heat dissipation surface 4b to the first heat dissipation surface 4a. This helps increase a heat dissipation surface of the heat dissipation substrate 4, thereby improving heat dissipation performance of the heat dissipation substrate 4.

In this application, to improve heat dissipation performance of the heat dissipation structure 100, a heat conducting layer may be further disposed between the first top surface 1011 and the first heat sink 2, and a heat conducting layer may also be disposed between the first bottom surface 1012 and the heat dissipation substrate 4. In addition, a heat conducting layer may also be disposed on a surface of each of the first protrusion part 201 and the second protrusion part 401.

According to the heat dissipation structure 100 provided in this embodiment of this application, the first heat sink 2 is disposed on the first top surface 1011 of the first frame 101, and the first bottom surface 1012 of the first frame 101 is in contact with the heat dissipation substrate 4. In this way, a heat dissipation path may be formed between the first frame 101 and each of the first heat sink 2 and the heat dissipation substrate 4, so that double-sided heat dissipation can be implemented for the first insertion module accommodated in the first frame 101, thereby effectively improving heat dissipation efficiency of the first insertion module accommodated in the first frame 101.

It should be noted that, in some possible embodiments of this application, the heat dissipation structure 100 may further not include the first heat sink 2. FIG. 1b is a side view of another structure of the heat dissipation structure 100 according to an embodiment of this application. In the heat dissipation structure shown in FIG. 1b, the first elastic member 3 may be in direct contact with the first insertion module accommodated in the first frame 101, to press the first insertion module toward the first bottom surface 1012 under elastic force after the first insertion module is inserted into the first frame 101. In this way, a heat conduction path between the first insertion module and the heat dissipation substrate 4 may also be short. This helps improve heat dissipation efficiency of the heat dissipation substrate 4 for the first insertion module. In addition, other structures of the heat dissipation structure 100 shown in FIG. 1b may be disposed with reference to the foregoing embodiments. Details are not described herein again.

After a manner of disposing the heat dissipation structure 100 provided in this application is understood, the following describes a cooperation relationship between the heat dissipation structure 100 and the first insertion module 200 with reference to a process of inserting the first insertion module 200 into the heat dissipation structure 100.

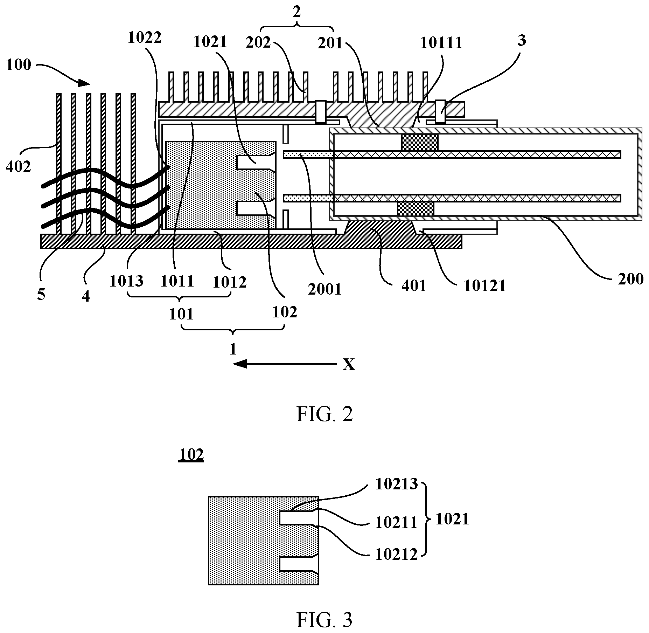

FIG. 2 is a diagram of a structure of the process of inserting the first insertion module 200 into the first frame component 1 according to an embodiment of this application. An X direction in FIG. 2 is a direction in which the first insertion module 200 is inserted into the first frame 101, and in a state shown in FIG. 2, a first signal end 2001 of the first insertion module 200 has not yet been inserted into the first connection end 1021 of the first connector 102, that is, the first insertion module 200 is not inserted into the first connector 102 in position.

In the state shown in FIG. 2, the first connector 102 abuts against the first bottom surface 1012, and a surface that is of a housing of the first insertion module 200 and that faces the first bottom surface 1012 abuts against the second protrusion part 401 that extends into the first frame 101. A center line of the first signal end 2001 of the first insertion module 200 is closer to the first top surface 1011 than a center line of the first connection end 1021 of the first insertion module 200. Therefore, the first signal end 2001 of the first insertion module 200 is not accurately aligned with the first connection end 1021 of the first connector 102 in the X direction.

To implement smooth insertion of the first signal end 2001 of the first insertion module 200 into the first connection end 1021 of the first connector 102, FIG. 3 is a diagram of a structure of the first connector 102 according to an embodiment of this application. The first connection end 1021 includes a fitting part 10213, and a first guiding surface 10211 and a second guiding surface 10212 that are located at the opening. The fitting part 10213 is configured to electrically come into contact with the first connection end 1021 after the first connection end 1021 is inserted, to transmit an electrical signal. The first guiding surface 10211 and the second guiding surface 10212 are configured to: perform guiding when the first signal end 2001 is not accurately aligned with the fitting part 10213 during an insertion process, and drive the first connector 102 to float, so that the first connection end 1021 may be finally inserted into the fitting part 10213. The first guiding surface 10211 and the second guiding surface 10212 are disposed opposite to each other. Refer to FIG. 2 and FIG. 3 together. The first guiding surface 10211 is closer to the first top surface 1011 than the second guiding surface 10212. In this way, the first signal end 2001 of the first insertion module 200 may be inserted between the first guiding surface 10211 and the second guiding surface 10212 into the first connection end 1021. In addition, still refer to FIG. 2 and FIG. 3. In a direction away from the first rear side surface 1013, a spacing between the first guiding surface 10211 and the second guiding surface 10212 gradually increases. In this way, the first connection end 1021 has an opening that expands outward. In this embodiment, the first guiding surface 10211 is mainly configured to: implement guidance and drive the first connector 102 to float. It may be understood that, before the first insertion module 200 is inserted into the first frame 101, when the first connector 102 abuts against the first top surface 1011, the second guiding surface 10212 may be further configured to: guide the first signal end 2001, and drive the first connector 102 to float.

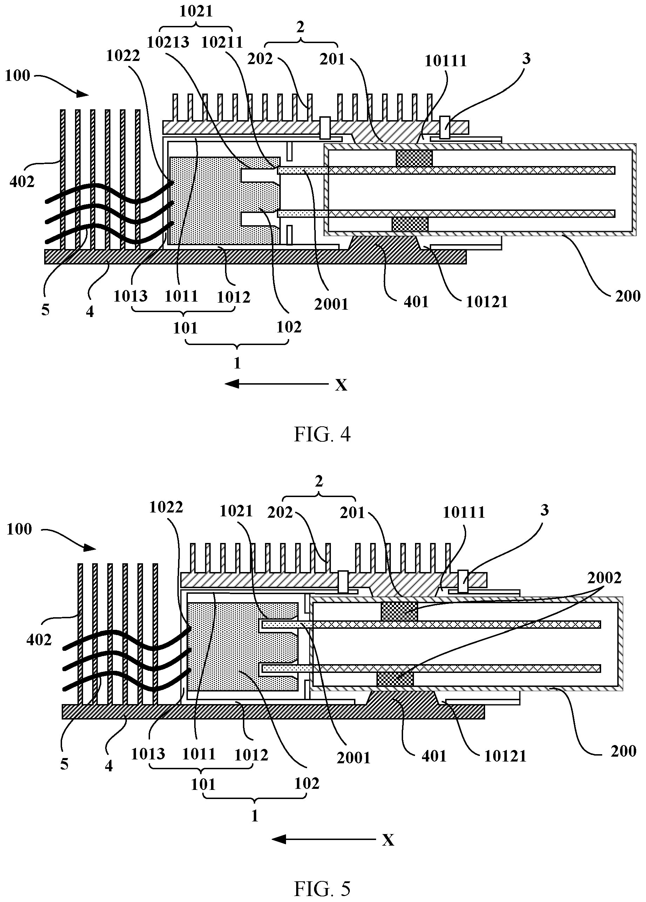

FIG. 4 is a diagram of another structure of the process of inserting the first insertion module 200 into the first frame component 1 according to an embodiment of this application. In a state shown in FIG. 4, an end part of the first signal end 2001 of the first insertion module 200 is in contact with the first guiding surface 10211. In this case, when the first insertion module 200 continues to be inserted into the first frame 101 in the X direction, the end part of the first signal end 2001 of the first insertion module 200 may slide into the first connection end 1021 along the first guiding surface 10211, so that the first signal end 2001 of the first insertion module 200 can be inserted into the first connection end 1021 under guidance of the first guiding surface 10211.

Refer to FIG. 4 and FIG. 5 together. It can be seen that although the first signal end 2001 of the first insertion module 200 is not accurately aligned with the first connection end 1021 in the process of inserting the first insertion module 200 into the first frame component 1 in the X direction, because there is no connection relationship between the first connector 102 and the first frame 101, in the process of inserting the first signal end 2001 of the first insertion module 200 into the first connection end 1021, the first signal end 2001 of the first insertion module 200 may drive, through a guiding surface (for example, 10211) of the first connector 102, the first connector 102 to float between the first bottom surface 1012 and the first top surface 1011, to insert the first signal end 2001 of the first insertion module 200 into the first connection end 1021 of the first connector 102. It may be understood that, to enable the first signal end 2001 to drive the first connector 102 to float, during design, it may be ensured that after the first insertion module 200 is inserted into the first frame 101, a height of the first signal end 2001 is between the fitting part 10213 and a highest position of the first guiding surface 10211 within a tolerance range, so that a connection to the fitting part 10213 through the first guiding surface 10211 can be finally implemented. In the process of inserting the first signal end 2001 of the first insertion module 200 into the first connection end 1021 of the first connector 102, the first insertion module 200 is in contact with the first protrusion part 201 of the first heat sink 2 under elastic force provided by the first elastic member 3. In this case, the first insertion module 200 is difficult to float. Therefore, the first connector 102 may float between the first top surface 1011 and the first bottom surface 1012, to ensure that the first insertion module 200 can be accurately connected to the first connector 102.

In the heat dissipation structure 100 provided in this application, the first guiding surface 10211 and the second guiding surface 10212 are disposed on the first connection end 1021 of the first connector 102, so that guidance in the process of inserting the first insertion module 200 can be implemented and the first connector 102 can be driven to float. This can reduce design precision of the heat dissipation structure 100, and help reduce assembly precision of the first insertion module 200 and the heat dissipation structure 100, thereby improving insertion efficiency of the first insertion module 200 and the heat dissipation structure 100, and reducing design costs.

FIG. 5 is a diagram of another structure of the process of inserting the first insertion module 200 into the first frame 101 according to an embodiment of this application. FIG. 5 shows a state in which the first signal end 2001 of the first insertion module 200 is inserted into the first connection end 1021 of the first connector 102 in position, or may also be understood as a diagram of a structure of the communication device including the first insertion module 200 and the heat dissipation structure 100. In this state, an end surface that is of the housing of the first insertion module 200 and that faces the first rear side surface 1013 abuts against the first stop part 1014. Therefore, in the process of inserting the first signal end 2001 of the first insertion module 200 into the first connection end 1021 of the first connector 102, the first stop part 1014 may further play a role of stopping the first insertion module 200, which can effectively reduce a risk that the first signal end 2001 of the first insertion module 200 or the first connection end 1021 of the first connector 102 is damaged due to excessively large insertion force applied to the first insertion module 200.

In addition, in the state shown in FIG. 5, when the first insertion module 200 is removed from the first frame 101, after the first insertion module 200 is inserted into the first connector 102, the first signal end 2001 of the first insertion module 200 is in close contact with the first connection end 1021 of the first connector 102. For example, an elastic member (not shown in the figure) like a spring plate is usually disposed inside the first connection end 1021 of the first connector 102 to tightly press the inserted first signal end 2001. Therefore, when the first insertion module 200 moves in a direction opposite to the X direction, the first connector 102 is also driven by the first insertion module 200 under friction force between the first signal end 2001 and the first connection end 1021 to move in the direction opposite to the X direction.

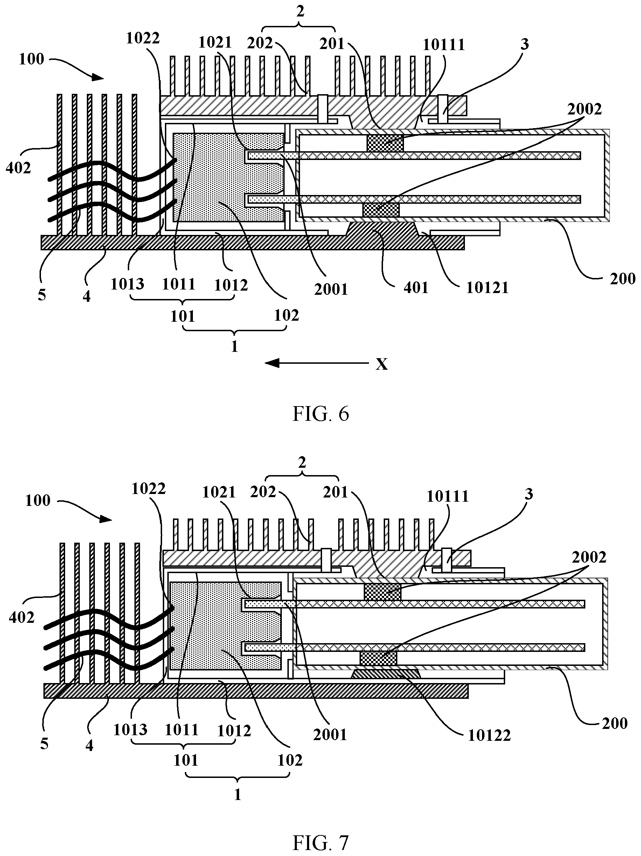

FIG. 6 is a diagram of a structure of a process of removing the first insertion module 200 from the first frame 101 according to an embodiment of this application. When the first connector 102 abuts against the first stop part 1014, the first connector 102 stops moving in the direction opposite to the X direction. In this case, the first insertion module 200 may be removed from the first frame 101 by continuing to apply removal force in the direction opposite to the X direction to the first insertion module 200, thereby preventing the first connector 102 from falling off from the first frame 101 with the first insertion module 200.

In the heat dissipation structure 100 provided in this application, the first elastic member 3 always presses the first protrusion part 201 of the first heat sink 2 into the first frame 101 under elastic force. Therefore, in the process of inserting the first insertion module 200 into the first frame 101 or removing the first insertion module 200 from the first frame 101, the first protrusion part 201 may always press against a surface that is of the housing of the first insertion module 200 and that faces the first top surface 1011. In addition, the first protrusion part 201 may further press the first insertion module 200 toward the second protrusion part 401 under elastic force of the first elastic member 3, so that the surface that is of the housing of the first insertion module 200 and that faces the first bottom surface 1012 always presses against the second protrusion part 401. In this way, insertion and removal stability between the first signal end 2001 of the first insertion module 200 and the first connection end 1021 of the first connector 102 can be improved, thereby helping prolong service lives of the first insertion module 200 and the first connector 102.

In addition, when the first insertion module 200 is inserted into the first connector 102 in position, a portion of heat generated by a heat source 2002 of the first insertion module may be conducted to the first protrusion part 201 through the housing of the first insertion module 200, and then conducted to the first heat sink 2. Another portion of the heat generated by the heat source 2002 of the first insertion module may be conducted to the second protrusion part 401 through the housing of the first insertion module 200, and then conducted to the heat dissipation substrate 4. In other words, one heat dissipation path is formed on each of two oppositely disposed surfaces of the first insertion module 200, and the heat dissipation paths can effectively improve heat dissipation efficiency of the first insertion module 200.

In addition, because all signals of the first connector 102 in the heat dissipation structure 100 provided in this application are connected to an external signal through the second connection end 1022 and the first cable 5, a circuit board does not need to be disposed on the first bottom surface 1012 of the first frame 101. Therefore, more space can be reserved on the first bottom surface 1012 of the first frame 101 for the heat dissipation substrate 4, to increase a contact area between the heat dissipation substrate 4 and the first bottom surface 1012 of the first frame 101, so as to improve heat dissipation performance of the heat dissipation structure 100.

FIG. 7 is a diagram of a structure of a communication device according to an embodiment of this application. Different from the communication device shown in FIG. 5, in the communication device shown in FIG. 7, the second window 10121 is not provided on the first bottom surface 1012 of the first frame 101, and the second protrusion part 401 is not disposed on the heat dissipation structure 100. However, a third protrusion part 10122 is disposed on the first bottom surface 1012, the third protrusion part 10122 protrudes from the first bottom surface 1012 in the direction from the first bottom surface 1012 to the first top surface 1011, and the third protrusion part 10122 may be configured to come into contact with the first insertion module 200. In this way, the first protrusion part 201 may press the first insertion module 200 toward the third protrusion part 10122 under elastic force of the first elastic member 3, so that a portion of heat generated by the heat source 2002 of the first insertion module may be conducted to the first protrusion part 201 through the housing of the first insertion module 200, and then conducted to the first heat sink 2. Another portion of the heat generated by the heat source 2002 of the first insertion module may be conducted to the third protrusion part 10122 through the housing of the first insertion module 200, and then conducted to the heat dissipation substrate 4 through the first bottom surface 1012 of the first frame 101, thereby still efficiently dissipating heat for the first insertion module 200 by the heat dissipation structure 100.

It should be noted that, in the communication device shown in FIG. 7, the heat dissipation substrate 4 may be in direct contact with the first bottom surface 1012. To improve heat conduction efficiency between the first bottom surface 1012 and the heat dissipation substrate 4, a thermally conductive structure like a thermally conductive layer may be disposed between the first bottom surface 1012 and the heat dissipation substrate 4, so that the heat dissipation substrate 4 is in indirect contact with the first bottom surface 1012. In addition, on the basis of the heat dissipation structure 100 of the communication device shown in FIG. 7, if the first bottom surface 1012 is a surface with a window, the heat dissipation substrate 4 may also be in direct contact with the first insertion module 200, to improve heat conduction efficiency between the heat dissipation substrate 4 and the first insertion module 200.

Other structures of the communication device shown in FIG. 7 may be disposed with reference to any one of the foregoing embodiments. Details are not described herein again.

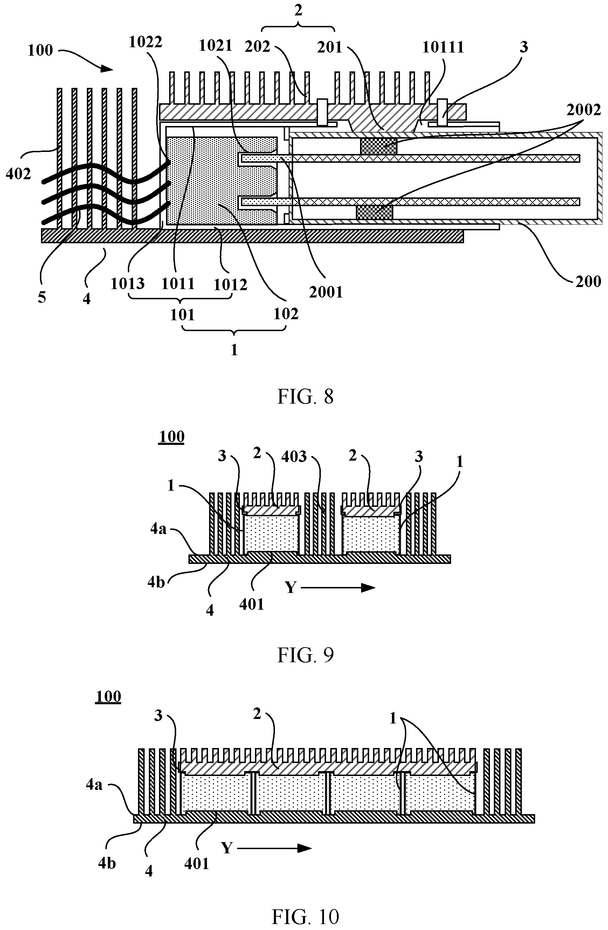

FIG. 8 is a diagram of another structure of the communication device according to an embodiment of this application. Different from the communication device shown in FIG. 5, in the communication device shown in FIG. 8, the second window 10121 is not provided on the first bottom surface 1012 of the first frame 101, and the second protrusion part 401 is not disposed on the heat dissipation structure 100. Instead, the first bottom surface 1012 is configured to abut against the first insertion module 200. In this way, the first protrusion part 201 may press the first insertion module 200 toward the first bottom surface 1012 under elastic force of the first elastic member 3, so that a portion of heat generated by the heat source 2002 of the first insertion module may be conducted to the first protrusion part 201 through the housing of the first insertion module 200, and then conducted to the first heat sink 2. Another portion of the heat generated by the heat source 2002 of the first insertion module may be conducted to the first bottom surface 1012 through the housing of the first insertion module 200, and then conducted to the heat dissipation substrate 4 through the first bottom surface 1012, thereby still efficiently dissipating heat for the first insertion module 200 by the heat dissipation structure 100.

In the communication device shown in FIG. 8, the heat dissipation substrate 4 may be in direct contact with the first bottom surface 1012. To improve heat conduction efficiency between the first bottom surface 1012 and the heat dissipation substrate 4, a thermally conductive structure like a thermally conductive layer may be disposed between the first bottom surface 1012 and the heat dissipation substrate 4, so that the heat dissipation substrate 4 is in indirect contact with the first bottom surface 1012. In addition, on the basis of the heat dissipation structure 100 of the communication device shown in FIG. 8, if the first bottom surface 1012 is a surface with a window, the heat dissipation substrate 4 may also be in direct contact with the first insertion module 200, to improve heat conduction efficiency between the heat dissipation substrate 4 and the first insertion module 200.

Other structures of the communication device shown in FIG. 8 may be disposed with reference to any one of the foregoing embodiments. Details are not described herein again.

As an amount of communication data of a communication device increases, more insertion modules are also disposed in the communication device. To meet signal transmission performance of the communication device, heat dissipation needs to be performed for each insertion module. The heat dissipation substrate 4 of the heat dissipation structure 100 provided in this application may simultaneously dissipate heat for a plurality of insertion modules. This can help increase arrangement density of the insertion modules while meeting a heat dissipation requirement of each insertion module. During specific implementation, FIG. 9 is a diagram of another structure of the communication device according to an embodiment of this application. FIG. 9 may be understood as a view of the structure of the communication device shown in FIG. 5 in the X direction. As shown in FIG. 9, the heat dissipation structure 100 of the communication device includes a plurality of first frame components 1, a plurality of first heat sinks 2, and a plurality of first elastic members 3. The plurality of first frame components 1 are sequentially arranged in a first direction. Refer to FIG. 5 and FIG. 9 together. The first direction is perpendicular to the direction from the first top surface 1011 to the first top surface 1011, and the first direction is parallel to the first rear side surface 1013. In embodiments of this application, for ease of description, the first direction may be denoted as a Y direction.

Still refer to FIG. 9. In this embodiment, the plurality of first frame components 1, the plurality of first heat sinks 2, and the plurality of first elastic members 3 are disposed in a one-to-one correspondence. Therefore, each first heat sink 2 is connected to a first top surface 1011 of one first frame 101 under elastic force of one first elastic member 3, and a first protrusion part 201 of each first heat sink 2 is inserted into a first window 10111 of a corresponding first frame 101. In addition, a first bottom surface 1012 of each first frame 101 is in contact with the first heat dissipation surface 4a of the heat dissipation substrate 4. Structures such as the first bottom surface 1012 of each first frame 101 and the heat dissipation substrate 4 may be disposed with reference to any one of the foregoing embodiments. Details are not described herein again.

In the communication device shown in FIG. 9, each first frame 101 of the heat dissipation structure 100 may correspondingly accommodate one first insertion module 200. A portion of heat generated by a heat source 2002 of each first insertion module may be conducted to a corresponding first heat sink 2, and another portion of the heat generated by the heat source 2002 of each first insertion module may be conducted to the same heat dissipation substrate 4. It can be learned from the foregoing descriptions of the heat dissipation structure 100 that, a circuit board does not need to be disposed on the bottom surface of the first frame 101, and a size of the heat dissipation substrate 4 may be set to be large. In this way, the same heat dissipation substrate 4 is used to dissipate heat for the plurality of first insertion modules 200, which can effectively improve a temperature equalization effect of the heat dissipation substrate 4 on the plurality of first insertion modules 200, thereby improving a heat dissipation effect of the heat dissipation substrate 4 on the plurality of first insertion modules 200.

In addition, in this embodiment, the heat dissipation substrate 4 may be a liquid cooling plate, to further improve the temperature equalization effect of the heat dissipation substrate 4 on the plurality of first insertion modules 200, so as to improve the heat dissipation effect of the heat dissipation substrate 4 on the plurality of first insertion modules 200.

Still refer to FIG. 9. In the heat dissipation structure 100 of the communication device, two adjacent first frame components 1 are spaced from each other. In this case, the third heat dissipation fin 402 of the heat dissipation substrate 4 may be disposed at a gap between the two adjacent first frame components 1. This helps improve a heat dissipation effect of the heat dissipation structure 100 on each first insertion module 200. In addition, a fin may further be disposed on the second heat dissipation surface 4b of the heat dissipation substrate 4, to further increase a heat dissipation area of the heat dissipation substrate 4, so as to improve heat dissipation performance of the heat dissipation structure 100.

FIG. 10 is a diagram of another structure of the communication device according to an embodiment of this application. FIG. 10 may be understood as a view of the another structure of the communication device shown in FIG. 5 in the X direction. As shown in FIG. 10, the heat dissipation structure 100 of the communication device also includes a plurality of first frame components 1, and the plurality of first frame components 1 are sequentially arranged in a Y direction. Different from the heat dissipation structure 100 of the communication device shown in FIG. 9, in FIG. 10, the heat dissipation structure 100 includes at least one first heat sink 2 and at least one first elastic member 3. Refer to FIG. 5 and FIG. 10 together. One first heat sink 2 is pressed toward a first top surface 1011 of each first frame 101 of at least two adjacent first frame components 1 under elastic force of one first elastic member 3, and one first protrusion part 201 corresponding to a first window 10111 of each first frame 101 of the at least two adjacent first frame components 1 is disposed on the one first heat sink 2. In this case, each first protrusion part 201 of the one first heat sink 2 is inserted into the first window 10111 of the first top surface 1011 of each first frame 101 of the at least two adjacent first frame components 1 in a one-to-one correspondence. In this way, one first heat sink 2 can simultaneously dissipate heat for at least two first insertion modules 200. In this way, a quantity of first heat sinks 2 in the heat dissipation structure 100 can be decreased, thereby simplifying a structure of the heat dissipation structure 100.

It may be understood that, when the size of the first heat sink 2 is large enough, first frame components 1 in the heat dissipation structure 100 may alternatively share one first heat sink 2, thereby simplifying the structure of the heat dissipation structure 100. In addition, in a possible embodiment, at least two first frame components 1 in the heat dissipation structure 100 may further share one first heat sink 2, and another first frame components 1 in the heat dissipation structure 100 is connected to one first heat sink 2 in a one-to-one correspondence, which can improve disposing flexibility of the heat dissipation structure 100.

In addition, as shown in FIG. 10, in this application, a plurality of first frames 101 of a plurality of first frame components 1 may be of an integrated structure. This helps increase a quantity of first frame components 1 disposed on the same heat dissipation substrate 4, thereby increasing arrangement density of insertion modules in the communication device, to meet a communication requirement of the communication device.

Still refer to FIG. 10. A first bottom surface 1012 of each first frame 101 is in contact with the first heat dissipation surface 4a of the heat dissipation substrate 4. In addition, structures such as the first bottom surface 1012 of each first frame 101 and the heat dissipation substrate 4 may be disposed with reference to any one of the foregoing embodiments. Details are not described herein again.

In the communication device shown in FIG. 10, each first frame 101 of the heat dissipation structure 100 may correspondingly accommodate one first insertion module 200. A portion of heat generated by a heat source 2002 of each first insertion module may be conducted to a corresponding first heat sink 2, and another portion of the heat generated by the heat source 2002 of each first insertion module may be conducted to the same heat dissipation substrate 4. It can be learned from the foregoing descriptions of the heat dissipation structure 100 that, a circuit board does not need to be disposed on the bottom surface of the first frame 101, and a size of the heat dissipation substrate 4 may be set to be large. In this way, the same heat dissipation substrate 4 is used to dissipate heat for the plurality of first insertion modules 200, which can effectively improve a temperature equalization effect of the heat dissipation substrate 4 on the plurality of first insertion modules 200, thereby improving a heat dissipation effect of the heat dissipation substrate 4 on the plurality of first insertion modules 200.

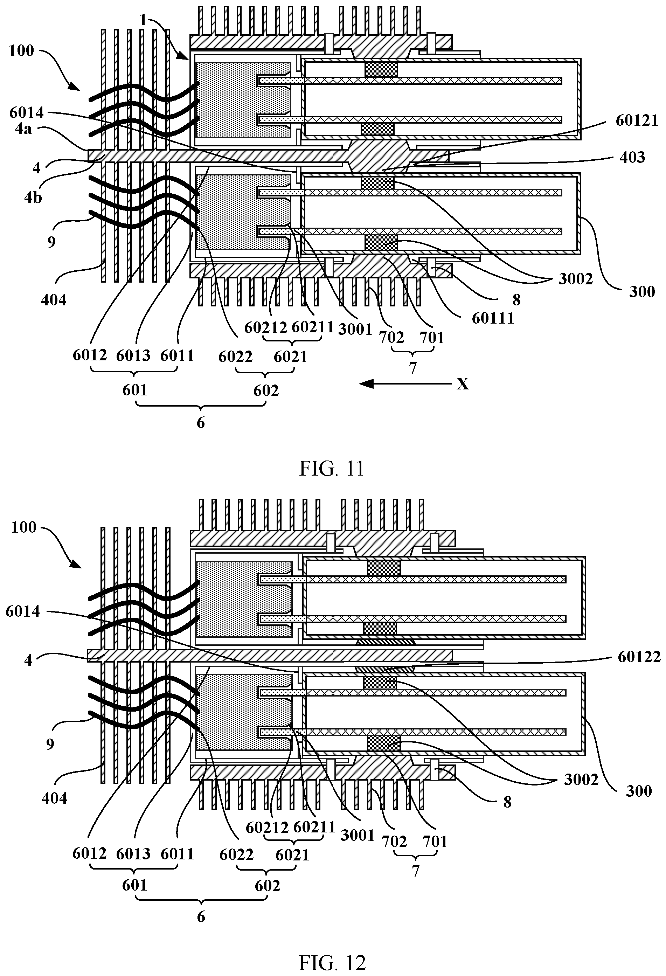

In addition, considering that the heat dissipation substrate 4 includes two heat dissipation surfaces disposed opposite to each other, in the heat dissipation structure 100 provided in this embodiment of this application, a frame component configured to accommodate an insertion module may be further disposed on the second heat dissipation surface 4b of the heat dissipation substrate 4. FIG. 11 is a diagram of another structure of the communication device according to an embodiment of this application. The communication device further includes a second insertion module 300, and the heat dissipation structure 100 further includes a second frame component 6, a second heat sink 7, and a second elastic member 8. The second frame component 6 includes a second frame 601 and a second connector 602. The second frame 601 includes a second top surface 6011, a second bottom surface 6012, and a second rear side surface 6013. The second top surface 6011 and the second bottom surface 6012 are disposed opposite to each other, and the second rear side surface 6013 is located between the second top surface 6011 and the second bottom surface 6012.

In this application, both the "top" and the "bottom" of the second frame 601 are also based on the heat dissipation substrate 4. To be specific, a side that is of the second frame 601 and that is away from the heat dissipation substrate 4 is the "top", and a side that is of the second frame 601 and that is close to the heat dissipation substrate 4 is the "bottom". In addition, the "rear" of the second frame 601 is a side opposite an insertion port of the second frame 601. In this application, for the second top surface 6011 and the second bottom surface 6012 of the second frame 601, refer to disposing of the surfaces of the first frame 101. Details are not described in this application again.

As shown in FIG. 11, the second frame 601 is configured to accommodate a second insertion module 300, and the second top surface 6011 of the second frame 601 includes a third window 60111. The second heat sink 7 is disposed on the second top surface 6011, the second heat sink 7 includes a fourth protrusion part 701, the fourth protrusion part 701 is inserted into the third window 60111, and at least a portion of the fourth protrusion part 701 is located in the second frame 601. In addition, the second elastic member 8 is connected to the second top surface 6011, and the second elastic member 8 is configured to: when the second insertion module 300 is inserted into the second frame 601, press the fourth protrusion part 701 into the second frame 601 under elastic force, so that the fourth protrusion part 701 always presses against, under elastic force of the second elastic member 8, a surface that is of a housing of the second insertion module 300 and that faces the second top surface 6011. This helps improve heat dissipation efficiency of the second heat sink 7 for the second insertion module 300.

In this application, the second elastic member 8 may be disposed with reference to the first elastic member 3. Details are not described herein. In addition, the second heat sink 7 may be disposed with reference to the first heat sink 2. Details are not described herein.

In addition, still refer to FIG. 11. The heat dissipation substrate 4 is located between the second frame component 6 and the first frame component 1, and the heat dissipation substrate 4 is located below the second bottom surface 6012 of the second frame 601. In this application, below the second bottom surface 6012 means on a side that is of the second bottom surface 6012 and that is away from the second top surface 6011.

In this embodiment of this application, the heat dissipation substrate 4 is configured to dissipate heat for the second insertion module 300 by coming into contact with the second bottom surface 6012 and/or the second insertion module 300 accommodated in the second frame 601. During specific implementation, at least a portion of the second bottom surface 6012 is in contact with the second heat dissipation surface 4b of the heat dissipation substrate 4. In this case, the second frame component 6 and the first frame component 1 share one heat dissipation substrate 4. This helps reduce a size of the heat dissipation structure 100, and can improve temperature uniformity of the heat dissipation substrate 4 for the first frame component 1 and the second frame component 6, thereby improving heat dissipation efficiency.

In this application, the second bottom surface 6012 of the second frame 601 may be connected to the heat dissipation substrate 4 with reference to a connection manner between the first bottom surface 1012 of the first frame 101 and the heat dissipation substrate 4. Details are not described herein again.

In the heat dissipation structure 100 of the communication device shown in FIG. 11, the second bottom surface 6012 of the second frame 601 includes a fourth window 60121, the heat dissipation substrate 4 further includes a fifth protrusion part 403, the fifth protrusion part 403 is inserted into the fourth window 60121, and at least a portion of the fifth protrusion part 403 is located in the second frame 601. In this way, the fourth protrusion part 701 may press the second insertion module 300 toward the fifth protrusion part 403 under elastic force of the second elastic member 8, so that a portion of heat generated by a heat source 3002 of the second insertion module may be conducted to the fourth protrusion part 701 through the housing of the second insertion module 300, and then conducted to the second heat sink 7. Another portion of the heat generated by the heat source 3002 of the second insertion module may be conducted to the fifth protrusion part 403 through the housing of the second insertion module 300, and then conducted to the heat dissipation substrate 4 through the second bottom surface 6012 of the second frame 601, thereby efficiently dissipating heat for the second insertion module 300.

It should be noted that, in the heat dissipation structure 100 shown in FIG. 11, there is no necessary relationship between disposing positions of the fourth protrusion part 701 and the fifth protrusion part 403, and the disposing positions may be specifically set based on a specific heat dissipation requirement and the like.

In addition, in the embodiment shown in FIG. 11, the second elastic member 8 indirectly presses the first insertion module toward the second bottom surface 6012 through the first heat sink 2 under elastic force. However, in some other possible embodiments of this application, the heat dissipation structure 100 may not be provided with the second heat sink 7. In this case, the second elastic member 8 may be in direct contact with the second insertion module 300 accommodated in the second frame 601, to press, after the second insertion module 300 is inserted into the second frame 601, the second insertion module 300 toward the second bottom surface 6012 under elastic force. In this way, a heat conduction path between the second insertion module 300 and the heat dissipation substrate 4 may also be short. This helps improve heat dissipation efficiency of the heat dissipation substrate 4 for the second insertion module 300.

As shown in FIG. 11, the second heat sink 7 further includes a second heat dissipation fin 702, and the second heat dissipation fin 702 extends in a direction from the second bottom surface 6012 to the second top surface 6011. This helps increase a heat dissipation area of the second heat sink 7, thereby improving heat dissipation performance of the second heat sink 7. In addition, in the heat dissipation structure 100 provided in this embodiment of this application, the heat dissipation substrate 4 may further include a fourth heat dissipation fin 404. The fourth heat dissipation fin 404 extends in a direction from the first heat dissipation surface 4a to the second heat dissipation surface 4b, and the fourth heat dissipation fin 404 may be located on a peripheral side of the second frame component 6. This helps increase a heat dissipation surface of the heat dissipation substrate 4, thereby improving heat dissipation performance of the heat dissipation substrate 4.

In this embodiment of this application, for disposing of the second connector 602 of the second frame component 6, refer to disposing of the first connector 102 of the first frame component 1. Simply speaking, the second connector 602 is located in a cavity of the second frame 601 close to the second rear side surface 6013. The second connector 602 includes a third connection end 6021 and a fourth connection end 6022. The third connection end 6021 is electrically connected to the fourth connection end 6022, the fourth connection end 6022 is configured to connect to a second cable 9, and the second cable 9 may alternatively be a flexible conductive medium like a conducting wire or a flexible circuit board. In this application, all signals of the second connector 602 are connected to an external signal through the fourth connection end 6022 and the second cable 9. In other words, a circuit board does not need to be disposed on the second bottom surface 6012 of the second frame 601. Therefore, more space may be reserved on the second bottom surface 6012 of the second frame 601 for the heat dissipation substrate 4, to increase a contact area between the heat dissipation substrate 4 and the second bottom surface 6012 of the second frame 601, so as to improve heat dissipation performance of the heat dissipation structure 100.

To implement smooth insertion between the second signal end 3001 of the second insertion module 300 and the third connection end 6021 of the second connector 602, as shown in FIG. 11, an opening of the third connection end 6021 includes a third guiding surface 60211 and a fourth guiding surface 60212. The third guiding surface 60211 and the fourth guiding surface 60212 are disposed opposite to each other, and the third guiding surface 60211 is closer to the second top surface 6011 than the fourth guiding surface 60212. In this way, the second signal end 3001 of the second insertion module 300 may be inserted 6021 between the third guiding surface 60211 and the fourth guiding surface 60212 into the third connection end. In addition, in a direction away from the second rear side surface 6013, a spacing between the third guiding surface 60211 and the fourth guiding surface 60212 gradually increases. In this way, the third connection end 6021 has an opening that expands outward, so that during insertion between the second insertion module 300 and the second connector 602, the third guiding surface 60211 and the fourth guiding surface 60212 guide the second signal end 3001 of the second insertion module 300, thereby improving efficiency of insertion between the second insertion module 300 and the second connector 602.

It may be understood that processes of insertion and removal between the second insertion module 300 and the second frame component 6 are similar to the foregoing processes of insertion and removal between the first insertion module 200 and the first frame component 1. Details are not described herein again. It should be noted that, in the process of inserting the second insertion module 300 into the second frame component 6, when the second signal end 3001 of the second insertion module 300 is not accurately aligned with the third connection end 6021, the second connector 602 may float between the second top surface 6011 and the second bottom surface 6012 under driving of the second signal end 3001 of the second insertion module 300, to implement effective insertion between the second signal end 3001 of the second insertion module 300 and the third connection end 6021.

In addition, as shown in FIG. 11, the second frame 601 further includes a second stop part 6014, the second stop part 6014 is located in the second frame 601, and the second stop part 6014 is connected to at least one of the second top surface 6011 and the second bottom surface 6012. In a process of inserting the second signal end 3001 of the second insertion module 300 into the third connection end 6021 of the second connector 602, the second stop part 6014 may play a role of stopping the second insertion module 300, which can effectively reduce a risk that the second signal end 3001 of the second insertion module 300 or the third connection end 6021 of the second connector 602 is damaged due to excessively large insertion force applied to the second insertion module 300. In addition, when the second insertion module 300 is removed from the second connector 602, the second stop part 6014 may be configured to limit movement of the second connector 602 in the direction away from the second rear side surface 6013, thereby preventing the second connector 602 from falling off from the second frame 601 with the second insertion module 300. In this embodiment of this application, the second stop part 6014 may be specifically disposed with reference to the first stop part 1014 in any one of the foregoing embodiments. Details are not described herein again.

Based on the manner of disposing the second frame component 6 provided in the foregoing embodiment, some adaptive deformation may be further performed on a structure of the second frame component 6. For example, FIG. 12 is a diagram of another structure of the communication device according to an embodiment of this application. In FIG. 12, a sixth protrusion part 60122 is disposed on the second bottom surface 6012, and the sixth protrusion part 60122 protrudes from the second bottom surface 6012 in the direction from the second bottom surface 6012 to the second top surface 6011. In this way, the fourth protrusion part 701 may press the second insertion module 300 toward the sixth protrusion part 60122 under elastic force of the second elastic member 8, so that a portion of heat generated by a heat source 3002 of the second insertion module may be conducted to the fourth protrusion part 701 through the housing of the second insertion module 300, and then conducted to the second heat sink 7. Another portion of the heat generated by the heat source 3002 of the second insertion module may be conducted to the sixth protrusion part 60122 through the housing of the second insertion module 300, and then conducted to the heat dissipation substrate 4 through the second bottom surface 6012 of the second frame 601, thereby efficiently dissipating heat for the second insertion module 300 by the heat dissipation structure 100.

It should be noted that, in the communication device shown in FIG. 12, to improve heat conduction efficiency between the second bottom surface 6012 and the heat dissipation substrate 4, a thermally conductive structure like a thermally conductive layer may be disposed between the second bottom surface 6012 and the heat dissipation substrate 4. In addition, other structures of the communication device shown in FIG. 12 may be disposed with reference to any one of the foregoing embodiments. Details are not described herein again.

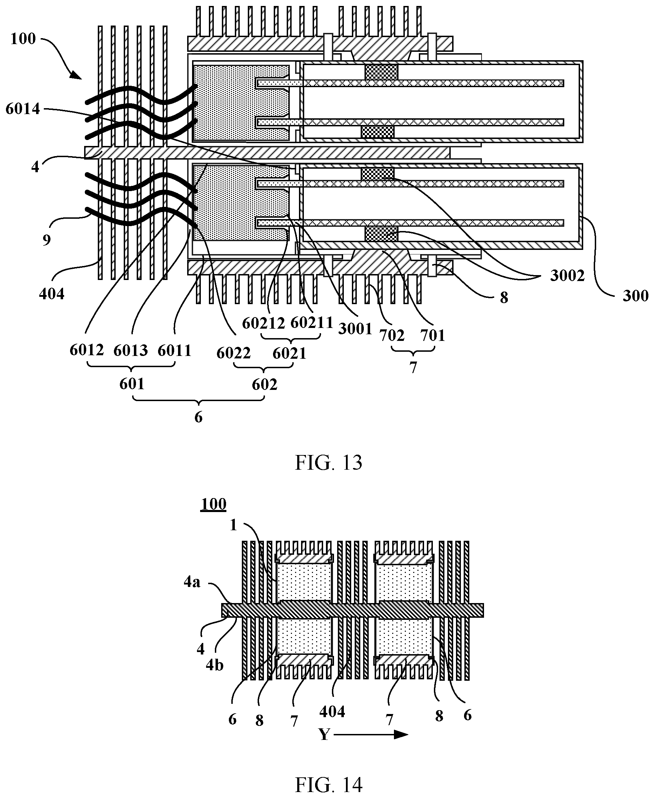

FIG. 13 is a diagram of another structure of the communication device according to an embodiment of this application. Different from the communication device shown in FIG. 12, in the communication device shown in FIG. 13, the second bottom surface 6012 is configured to directly come into contact with the second insertion module 300. In this way, the fourth protrusion part 701 may press the second insertion module 300 toward the second bottom surface 6012 under elastic force of the second elastic member 8, so that a portion of heat generated by the heat source 2002 of the first insertion module may be conducted to the fourth protrusion part 701 through the housing of the first insertion module 200, and then conducted to the second heat sink 7. Another portion of the heat generated by the heat source 3002 of the second insertion module may be conducted to the second bottom surface 6012 through the housing of the first insertion module 200, and then conducted to the heat dissipation substrate 4 through the second bottom surface 6012, thereby implementing effective heat dissipation of the second insertion module 300 by the heat dissipation structure 100.

In the communication device shown in FIG. 13, to improve heat conduction efficiency between the second bottom surface 6012 and the heat dissipation substrate 4, a thermally conductive structure like a thermally conductive layer may be disposed between the second bottom surface 6012 and the heat dissipation substrate 4. In addition, other structures of the communication device shown in FIG. 13 may be disposed with reference to any one of the foregoing embodiments. Details are not described herein again.

FIG. 14 is a diagram of another structure of the communication device according to an embodiment of this application. FIG. 14 may be understood as a view of the structure of the communication device shown in FIG. 11 in the X direction. The heat dissipation structure 100 of the communication device includes a plurality of second frame components 6, a plurality of second heat sinks 7, and a plurality of second elastic members 8, where the plurality of second frame components 6 are sequentially arranged in a Y direction.

In the embodiment shown in FIG. 14, the plurality of second frame components 6, the plurality of second heat sinks 7, and the plurality of second elastic members 8 are disposed in a one-to-one correspondence. Therefore, each second heat sink 7 is connected to a second top surface 6011 of one second frame 601 under elastic force of one second elastic member 8, and a fourth protrusion part 701 of each second heat sink 7 is inserted into a third window 60111 of a corresponding second frame 601. In addition, a second bottom surface 6012 of each second frame 601 is in contact with the second heat dissipation surface 4b of the heat dissipation substrate 4. Structures such as the second bottom surface 6012 of each second frame 601 and the heat dissipation substrate 4 may be disposed with reference to any one of the foregoing embodiments. Details are not described herein again.

In the communication device shown in FIG. 14, each second frame of the heat dissipation structure 100 may correspondingly accommodate one second insertion module 300. A portion of heat generated by a heat source 3002 of each second insertion module may be conducted to a corresponding second heat sink 7, and another portion of the heat generated by the heat source 3002 of each second insertion module may be conducted to the same heat dissipation substrate 4. It can be learned from the foregoing descriptions of the heat dissipation structure 100 that, a circuit board does not need to be disposed on the bottom surface of the first frame 101, and a size of the heat dissipation substrate 4 may be set to be large. In this way, the same heat dissipation substrate 4 is used to dissipate heat for the plurality of second insertion modules 300, which can effectively improve a temperature equalization effect of the heat dissipation substrate 4 on the plurality of first insertion modules 200, thereby improving a heat dissipation effect of the heat dissipation substrate 4 on the plurality of first insertion modules 200.

Still refer to FIG. 14. Two adjacent second frame components 6 are spaced from each other. In this case, the fourth heat dissipation fin 404 of the heat dissipation substrate 4 may be disposed at a gap between the two adjacent second frame components 6. This helps improve a heat dissipation effect of the heat dissipation structure 100 on each second insertion module 300.

In the heat dissipation structure 100 of the communication device shown in FIG. 14, the plurality of first frame components 1 and the plurality of second frame components 6 are all disposed on the same heat dissipation substrate 4. This helps improve temperature equalization of the heat dissipation structure 100, thereby improving heat dissipation performance of the heat dissipation structure 100. In addition, in the heat dissipation structure 100, a quantity of the plurality of first frame components 1 is the same as a quantity of the plurality of second frame components 6, and in the direction from the first heat dissipation surface 4a to the second heat dissipation surface 4b of the heat dissipation substrate 4, each first frame component 1 is disposed opposite to one second frame component 6. In this case, the plurality of first frame components 1 and the plurality of second frame components 6 are disposed in a one-to-one correspondence. This is conducive to a miniaturization design of the heat dissipation structure 100. In this way, when space for disposing the heat dissipation structure 100 in the communication device is limited, more first frame components 1 and second frame components 6 can be disposed, so that more first insertion modules 200 and second insertion modules 300 can be inserted, to meet a communication requirement of the communication device.

It should be noted that, in this embodiment of this application, the quantity of first frame components 1 and the quantity of second frame components 6 in the heat dissipation structure 100 may be the same or different, and the first frame components 1 and the second frame components 6 may be disposed oppositely or alternately. This is not limited in this application.

In addition, when the communication device includes a plurality of first insertion modules 200, the plurality of first insertion modules 200 may be of a same type or different types, and first connectors 102 of a plurality of corresponding first frame components 1 in the heat dissipation structure 100 may also be of a same type or different types. The type may be specifically selected based on a specific application scenario. Similarly, when the communication device includes a plurality of second insertion modules 300, the plurality of second insertion modules 300 may be of a same type or different types, and second connectors 602 of a plurality of corresponding second frame components 6 in the heat dissipation structure 100 may also be of a same type or different types. The type may be specifically selected based on a specific application scenario.

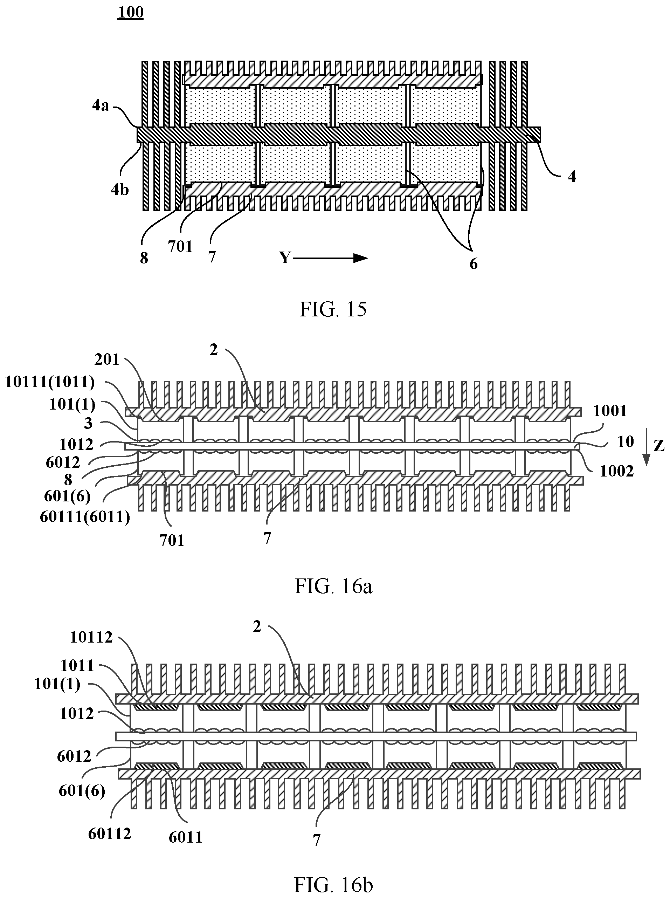

FIG. 15 is a diagram of another structure of the communication device according to an embodiment of this application. FIG. 15 may be understood as a view of the another structure of the communication device shown in FIG. 11 in the X direction. Different from the heat dissipation structure 100 of the communication device shown in FIG. 14, in FIG. 15, the heat dissipation structure 100 includes at least one second heat sink 7 and at least one second elastic member 8. One second heat sink 7 is pressed toward a second top surface 6011 of each second frame 601 of at least two adjacent second frame components 6 under elastic force of one second elastic member 8, and one fourth protrusion part 701 corresponding to a third window 60111 of each second frame 601 of the at least two adjacent second frame components 6 is disposed on the one second heat sink 7. In this case, each fourth protrusion part 701 of the one second heat sink 7 is inserted into the third window 60111 of the second top surface 6011 of each second frame 601 of the at least two adjacent second frame components 6 in a one-to-one correspondence. In this way, one second heat sink 7 can simultaneously dissipate heat for at least two second insertion modules 300. In this way, a quantity of second heat sinks 7 in the heat dissipation structure 100 can be decreased, thereby simplifying a structure of the heat dissipation structure 100. It may be understood that, when the size of the second heat sink 7 is large enough, second frame components 6 in the heat dissipation structure 100 may alternatively share one second heat sink 7, thereby simplifying the structure of the heat dissipation structure 100.

In addition, as shown in FIG. 15, in this application, a plurality of second frames 601 of a plurality of second frame components 6 may be of an integrated structure. This helps increase a quantity of second frame components 6 disposed on the same heat dissipation substrate 4, thereby increasing arrangement density of insertion modules in the communication device, to meet a communication requirement of the communication device.

Still refer to FIG. 15. A second bottom surface 6012 of each second frame 601 is in contact with the second heat dissipation surface 4b of the heat dissipation substrate 4. In addition, structures such as the second bottom surface 6012 of each second frame 601 and the heat dissipation substrate 4 may be disposed with reference to any one of the foregoing embodiments. Details are not described herein again.

In the communication device shown in FIG. 15, each second frame 601 of the heat dissipation structure 100 may correspondingly accommodate one second insertion module 300. A portion of heat generated by a heat source 3002 of each second insertion module may be conducted to a corresponding second heat sink 7, and another portion of the heat generated by the heat source 3002 of each second insertion module may be conducted to the same heat dissipation substrate 4. It can be learned from the foregoing descriptions of the heat dissipation structure 100 that, a circuit board does not need to be disposed on the bottom surface of the second frame 601, and a size of the heat dissipation substrate 4 may be set to be large. In this way, the same heat dissipation substrate 4 is used to dissipate heat for the plurality of second insertion modules 300, which can effectively improve a temperature equalization effect of the heat dissipation substrate 4 on the plurality of second insertion modules 300, thereby improving a heat dissipation effect of the heat dissipation substrate 4 on the plurality of second insertion modules 300.

FIG. 16a is a diagram of another structure of the communication device according to an embodiment of this application. Different from the embodiment shown in FIG. 15, in the communication device shown in FIG. 16a, the heat dissipation substrate 4 is replaced with a fastening substrate 10. The fastening substrate 10 includes a first support surface 1001 and a second support surface 1002 that are disposed opposite to each other. A plurality of first frame components 1 are located on a side that is of the first support surface 1001 and that is away from the second support surface 1002. A plurality of second frame components 6 are located on a side that is of the second support surface 1002 and that is away from the first support surface 1001. In other words, the fastening substrate 10 is located between the plurality of first frame components 1 and the plurality of second frame components 6.

In addition, a first frame 101 of each first frame component 1 and a second frame 601 of each second frame component 6 are both connected to the fastening substrate 10. In other words, the first frame 101 of each first frame component 1 may be connected to the first support surface 1001, and the second frame 601 of each second frame component 6 may be connected to the second support surface 1002. A connection manner may be, but is not limited to, welding, riveting, or threaded connection, so that the fastening substrate 10 can support the plurality of first frame components 1 and the plurality of second frame components 6.

It should be noted that, in this application, a material of the fastening substrate 10 is not limited, for example, may be a steel plate or the like with high rigidity, to improve structural strength of the fastening substrate 10, so as to ensure reliability of supporting the plurality of first frame components 1 and the plurality of second frame components 6.

It may be understood that a direction from the first support surface 1001 to the second support surface 1002 is a thickness direction of the fastening substrate 10. For ease of description, the direction may be defined as a Z direction. In this application, a thickness of the fastening substrate 10 is not limited, and may be adjusted based on layout space and the like in an actual application scenario. In addition, the thickness of the fastening substrate 10 may be adjusted, to adjust a spacing between the first frame component 1 and the second frame component 6 in the Z direction, so as to avoid interference between the first insertion module inserted into the first frame 101 and the second insertion module inserted into the second frame 601.

In the communication device shown in FIG. 16a, the plurality of first frame components 1 share one first heat sink 2. During specific implementation, the first heat sink 2 is connected to first top surfaces 1011 of a plurality of first frames 101 of the plurality of first frame components 1. A connection manner may be, but is not limited to, welding, riveting, threaded connection, or the like, to implement a rigid connection between the first heat sink 2 and the plurality of first frames 101. In addition, a first top surface 1011 of each first frame 101 is provided with a first window 10111, the first heat sink 2 includes a plurality of first protrusion parts 201, and the plurality of first protrusion parts 201 are inserted into first windows 10111 of the plurality of first frames 101 in a one-to-one correspondence.

Similarly, in the communication device shown in FIG. 16a, the plurality of second frame components 6 share one second heat sink 7. To be specific, the second heat sink 7 is connected to second top surfaces 6011 of a plurality of second frames 601 of the plurality of second frame components 6. For a connection manner, refer to the foregoing connection manner between the first heat sink 2 and the plurality of first frames 101. Details are not described herein again. In addition, a second top surface 6011 of each second frame 601 is provided with a third window 60111, the second heat sink 7 includes a plurality of fourth protrusion parts 701, and the plurality of fourth protrusion parts 701 are inserted into third windows 60111 of the plurality of second frames 601 in a one-to-one correspondence.

Still refer to FIG. 16a. In this embodiment, for each first frame component 1, a first elastic member 3 is disposed in a first frame 101, and the first elastic member 3 is connected to a first bottom surface 1012. In addition, the first elastic member 3 may be disposed as a spring plate, to simplify a structure of the first elastic member 3. In this way, the first elastic member 3 may be configured to press the first insertion module toward the first protrusion part 201 of the first heat sink 2 under elastic force after the first insertion module is inserted into the first frame 101, thereby implementing reliable heat dissipation of the first insertion module by the first heat sink 2.

In the embodiment shown in FIG. 16a, each first frame component 1 is separately provided with one first elastic member 3. In this way, the first elastic member 3 disposed in each first frame component 1 may be separately adjusted, so that the first insertion module correspondingly inserted into the first frame 101 of each first frame component 1 is in reliable contact with the first heat sink 2.

Similarly, for each second frame component 6, a second elastic member 8 may be disposed with reference to the first elastic member 3. Details are not described herein. In this way, the second elastic member 8 may be configured to always press the second insertion module toward the fourth protrusion part 701 of the second heat sink 7 under elastic force after the second insertion module is inserted into the second frame 601, thereby implementing reliable heat dissipation of the second insertion module by the second heat sink 7.

Based on the descriptions, in the foregoing embodiments, of the heat dissipation structure provided in this application, the communication device shown in FIG. 16a may be further deformed in a series of manners. For example, FIG. 16b is a diagram of another structure of the communication device according to an embodiment of this application. Different from the communication device shown in FIG. 16a, in the communication device shown in FIG. 16b, the first heat sink 2 is not provided with the first protrusion part 201, but a seventh protrusion part 10112 is provided on the first top surface 1011 of the first frame 101. The seventh protrusion part 10112 protrudes from the first top surface 1011 in a direction from the first top surface 1011 to the first bottom surface 1012. Therefore, the seventh protrusion part 10112 may be configured to come into contact with the first insertion module. In this way, the first elastic member 3 may press the first insertion module toward the seventh protrusion part 10112 under elastic force, so that heat generated by the heat source of the first insertion module may be conducted to the seventh protrusion part 10112 through the housing of the first insertion module, and then conducted to the first heat sink 2 through the first top surface 1011 of the first frame 101. In this way, the first heat sink 2 can still efficiently dissipate heat for the first insertion module.

In the communication device shown in FIG. 16b, the second frame component 6 may be disposed with reference to the first frame component 1. Simply speaking, an eighth protrusion part 60112 is disposed on the second top surface 6011 of the second frame 601. The eighth protrusion part 60112 protrudes from the second top surface 6011 in a direction from the second top surface 6011 to the second bottom surface 6012, and the eighth protrusion part 60112 may be configured to come into contact with the second insertion module, so that the second elastic member 8 may press the second insertion module toward the eighth protrusion part 60112 under elastic force. In this case, heat generated by the heat source of the second insertion module may be conducted to the eighth protrusion part 60112 through the housing of the second insertion module, and then conducted to the second heat sink 7 through the second top surface 6011 of the second frame 601. In this way, the second heat sink 7 can still efficiently dissipate heat for the second insertion module.

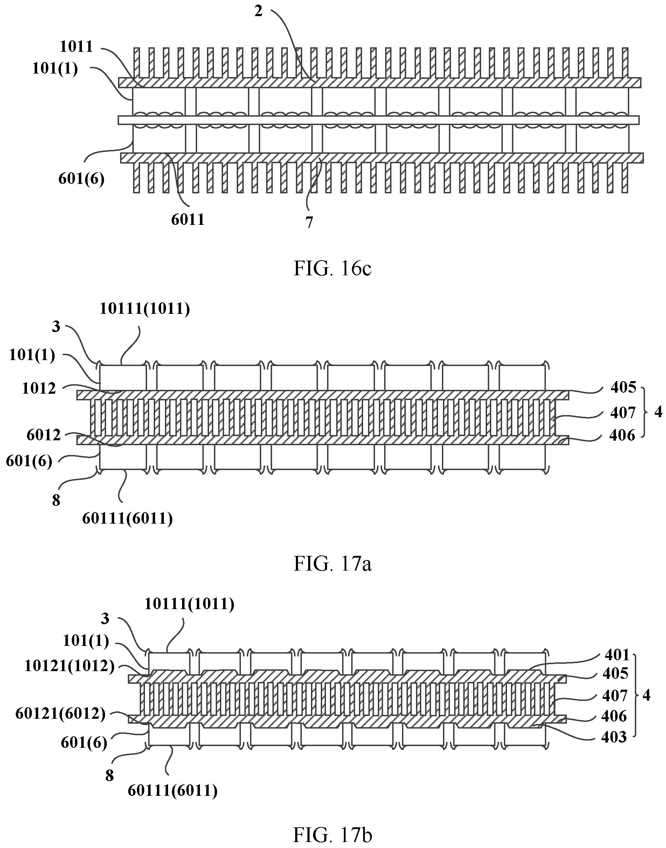

For another example, in the communication device shown in FIG. 16c, the first protrusion part 201 is not disposed on the first heat sink 2, and the third protrusion part 10122 is not disposed on the first frame 101. In this embodiment, the first insertion module may be pressed toward the first top surface 1011 by using elastic force of the first elastic member 3, so that the first insertion module may be in indirect contact with the first heat sink 2 through the first top surface 1011.

In addition, to improve heat dissipation efficiency between the first insertion module and the first heat sink 2, a thermally conductive structure like a thermally conductive layer may be further disposed between the first heat sink 2 and the first top surface 1011.

It may be understood that, in the communication device shown in FIG. 16c, the first top surface 1011 of the first frame 101 may further be provided with a first window 10111, and the first heat sink 2 covers the first window 10111. In addition, a thermally conductive structure like a thermally conductive layer may be disposed on a portion that is of the first heat sink 2 and that is opposite to the first window 10111. In this way, the first heat sink 2 can still efficiently dissipate heat for the first insertion module.

In the communication device shown in FIG. 16c, the second frame component 6 may be disposed with reference to the first frame component 1, and the second heat sink 7 may be disposed with reference to the first heat sink 2. Details are not described herein again. In addition, other structures of the communication device shown in FIG. 16b and FIG. 16c may be disposed with reference to FIG. 16a. Details are not described herein again.

FIG. 17a is a diagram of another structure of the communication device according to an embodiment of this application. Different from the foregoing embodiments, in the communication device shown in FIG. 17a, a manner of disposing the heat dissipation substrate 4 is changed. Specifically, the heat dissipation substrate 4 includes a first substrate 405, a second substrate 406, and a fifth heat dissipation fin 407. The first substrate 405 and the second substrate 406 are disposed opposite to each other, and the fifth heat dissipation fin 407 is located between the first substrate 405 and the second substrate 406, so that the first substrate 405 is connected to the second substrate 406 through the fifth heat dissipation fin 407. It may be understood that there may be a plurality of fifth heat dissipation fins 407 disposed side by side, to help increase a heat dissipation area of the heat dissipation substrate 4.

In addition, a plurality of first frame components 1 are located on a side that is of the first substrate 405 and that is away from the second substrate 406, and a plurality of second frame components 6 are located on a side that is of the second substrate 406 and that is away from the first substrate 405. Alternatively, it may be considered that the first substrate 405 is located below the first bottom surface 1012 of the first frame 101, and the second substrate 406 is located below the second bottom surface 6012 of the second frame 601. In addition, in this application, a first bottom surface 1012 of a first frame 101 of each first frame component 1 may be connected to the first substrate 405, and a second bottom surface 6012 of a second frame 601 of each second frame component 6 may be connected to the second substrate 406.

It may be understood that, in the embodiment shown in FIG. 17a, a surface that is of the first substrate 405 and that faces the first frame component 1 may be considered as a first heat dissipation surface of the heat dissipation substrate 4. A surface that is of the second substrate 406 and that faces the second frame component 6 may be considered as a second heat dissipation surface of the heat dissipation substrate 4.

In the communication device shown in FIG. 17a, for each first frame component 1, a first elastic member 3 is connected to a first top surface 1011 of the first frame 101. A specific manner of disposing the first elastic member 3 is not limited in this embodiment. For example, the first elastic member 3 may be located outside the first frame 101, and the first top surface 1011 of the first frame 101 is provided with a first window 10111. A fastening part of the first elastic member 3 is inserted into the first window 10111, so that the first elastic member 3 may be configured to provide elastic force toward the first bottom surface 1012 for the first insertion module inserted into the first frame 101. In this case, the first insertion module may always be in contact with the first bottom surface 1012. In this way, heat generated by the heat source of the first insertion module may be transferred to the first substrate 405 through the first bottom surface 1012, thereby implementing reliable heat dissipation of the first insertion module by the heat dissipation substrate 4.

In the embodiment shown in FIG. 17a, the second frame component 6 may be disposed with reference to the first frame component 1, so that the second elastic member 8 may be configured to always press the second insertion module inserted into the second frame 601 toward the second bottom surface 6012. In this way, heat generated by the heat source of the second insertion module may be transferred to the second substrate 406 through the second bottom surface 6012, thereby implementing reliable heat dissipation of the second insertion module by the heat dissipation substrate 4.

The communication device provided in this application uses the design manner shown in FIG. 17a, and can implement temperature equalization for the plurality of first insertion modules and the plurality of second insertion modules through the heat dissipation substrate 4. In addition, because the heat dissipation substrate 4 in this embodiment has a large heat dissipation area, this is conducive to improving a heat dissipation effect of the heat dissipation substrate 4 on the plurality of first insertion modules and the plurality of second insertion modules.

Based on the descriptions, in the foregoing embodiments, of the heat dissipation structure provided in this application, the communication device shown in FIG. 17a may be further deformed in a series of manners. For example, FIG. 17b is a diagram of another structure of the communication device according to an embodiment of this application. Different from the communication device shown in FIG. 17a, in the communication device shown in FIG. 17b, the first bottom surface 1012 of the first frame 101 is provided with a second window 10121. In addition, the first substrate 405 includes a plurality of second protrusion parts 401, and the plurality of second protrusion parts 401 are inserted into second windows 10121 of a plurality of first frames 101 in a one-to-one correspondence. In this way, the first insertion module inserted into the first frame 101 may be in direct contact with the second protrusion part 401 of the first substrate 405 under elastic force of the first elastic member 3. This helps improve heat conduction efficiency between the first insertion module and the first substrate 405, thereby improving a heat dissipation effect of the heat dissipation substrate 4 on the first insertion module.

As shown in FIG. 17b, the second bottom surface 6012 of the second frame 601 is provided with a fourth window 60121. The second substrate 406 includes a plurality of fifth protrusion parts 403, and the plurality of fifth protrusion parts 403 are inserted into fourth window 60121 of a plurality of second frames 601 in a one-to-one correspondence. In this way, the second insertion module inserted into the second frame 601 may be in direct contact with the fifth protrusion part 403 of the second substrate 406 under elastic force of the second elastic member 8. This helps improve heat conduction efficiency between the second insertion module and the second substrate 406, thereby improving a heat dissipation effect of the heat dissipation substrate 4 on the second insertion module.

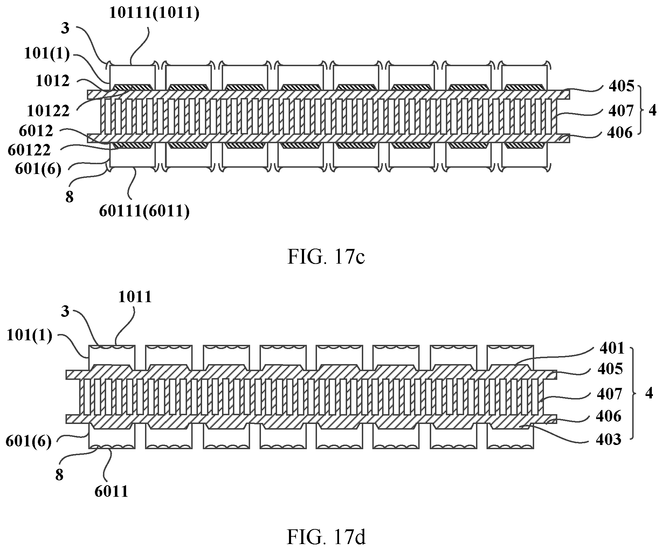

For another example, in the communication device shown in FIG. 17c, the first substrate 405 is not provided with the second protrusion part 401, but a third protrusion part 10122 is disposed in the first bottom surface 1012 of the first frame 101. The third protrusion part 10122 protrudes from the first bottom surface 1012 in a direction from the first bottom surface 1012 to the first top surface 1011. Therefore, the third protrusion part 10122 may be in contact with the first insertion module. In this way, the first elastic member 3 may press the first insertion module toward the third protrusion part 10122 under elastic force, so that heat generated by the heat source of the first insertion module may be conducted to the third protrusion part 10122 through the housing of the first insertion module, and then conducted to the first substrate 405 through the first bottom surface 1012 of the first frame 101. In this way, the heat dissipation substrate 4 can still efficiently dissipate heat for the first insertion module.

In the communication device shown in FIG. 17c, the second frame component 6 may be disposed with reference to the first frame component 1. Details are not described herein again.

In the communication device shown in FIG. 17d, in this embodiment, the first elastic member 3 is disposed inside the first frame 101. In addition, the first elastic member 3 may be but is not limited to a spring plate, provided that the first elastic member 3 can be configured to apply elastic force toward the heat dissipation substrate 4 to the first insertion module inserted into the first frame 101. Similarly, the second elastic member 8 may be disposed with reference to the first elastic member 3. Details are not described herein.

The foregoing embodiments are merely some example variations of specific manners of disposing the communication device. On this basis, quantities and structures of frame components, elastic members, and heat sinks on two sides of the heat dissipation substrate 4, cooperation between each frame component and the heat dissipation substrate 4, and the like may be alternatively disposed in any other possible combination manner. Details are not described one by one herein, but it should be understood that they all fall within the protection scope of this application.

In addition, in the foregoing embodiments of this application, the heat dissipation structure 100 and the communication device are described by using an example in which the communication device is a network communication device and the insertion module is an optical module. When the communication device is another type of communication device, the heat dissipation structure 100 may be disposed with reference to any one of the foregoing embodiments. For example, when the communication device is a server, the insertion module may be a hard disk. In this case, a frame of a frame component of the heat dissipation structure 100 may include only 12 frame edges. In this case, each surface of the frame may be understood as a surface with a window, and other structures of the heat dissipation structure 100 may be disposed with reference to any one of the foregoing embodiments. Details are not described herein again. Heat dissipation structures 100 of various types of communication devices are not described in this application, but it should be understood that they all fall within the protection scope of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An efficient heat dissipation structure for an insertion module, comprising a first frame component, a first elastic member, and a heat dissipation substrate, wherein the first frame component comprises a first frame and a first connector;
the first frame is configured to accommodate a first insertion module, the first frame comprises a first top surface, a first bottom surface, and a first rear side surface, the first top surface and the first bottom surface are disposed opposite to each other, and the first rear side surface is located between the first top surface and the first bottom surface;
the heat dissipation substrate is located below the first bottom surface, and is configured to dissipate heat for the first insertion module by coming into contact with the first bottom surface and/or the first insertion module;
the first connector is located in a cavity of the first frame close to the first rear side surface, the first connector comprises a first connection end and a second connection end, the first connection end is electrically connected to the second connection end, the second connection end is configured to connect to a first cable, and all signals of the first connector are connected to an external signal through the second connection end and the first cable;
the first insertion module comprises a first signal end, and when the first signal end is not accurately aligned in a process of being inserted into the first connection end, the first signal end is configured to drive the first connector to float between the first top surface and the first bottom surface; and
the first elastic member is connected to the first top surface, and the first elastic member is configured to: after the first insertion module is inserted into the first frame, press the first insertion module toward the first bottom surface under elastic force.

2. The heat dissipation structure according to claim 1, wherein the heat dissipation structure further comprises a first heat sink; and the first heat sink is disposed on the first top surface, the first top surface comprises a first window, and the first elastic member is configured to: after the first insertion module is inserted into the first frame, press the first insertion module toward the first bottom surface under elastic force through a portion that is of the first heat sink and that is opposite to the first window.

3. The heat dissipation structure according to claim 2, wherein the first heat sink comprises a first protrusion part, the first protrusion part is inserted into the first window, and at least a portion of the first protrusion part is located in the first frame; and the first elastic member is configured to: after the first insertion module is inserted into the first frame, press the first protrusion part toward the first insertion module under elastic force.

4. The heat dissipation structure according to claim 2 or 3, wherein a surface that is of the first heat sink and that is away from the heat dissipation substrate further comprises a first heat dissipation fin, and the first heat dissipation fin extends in a direction from the first bottom surface to the first top surface.

5. The heat dissipation structure according to any one of claims 1 to 4, wherein the first bottom surface comprises a second window; the heat dissipation substrate comprises a second protrusion part, the second protrusion part is inserted into the second window, and at least a portion of the second protrusion part is located in the first frame; and the second protrusion part is configured to come into contact with the first insertion module.

6. The heat dissipation structure according to any one of claims 1 to 4, wherein a third protrusion part is disposed on the first bottom surface, the third protrusion part protrudes from the first bottom surface in the direction from the first bottom surface to the first top surface, and the third protrusion part is configured to come into contact with the first insertion module.

7. The heat dissipation structure according to any one of claims 1 to 4, wherein the first bottom surface is configured to directly come into contact with the first insertion module.

8. The heat dissipation structure according to any one of claims 1 to 7, wherein an opening of the first connection end comprises a first guiding surface and a second guiding surface that are disposed opposite to each other, the first guiding surface is closer to the first top surface than the second guiding surface, and a spacing between the first guiding surface and the second guiding surface gradually increases in a direction away from the first rear side surface.

9. The heat dissipation structure according to any one of claims 1 to 8, wherein the first frame further comprises a first stop part, the first stop part is located in the first frame, the first stop part is connected to at least one of the first top surface and the first bottom surface, and the first stop part is configured to limit movement of the first connector in the direction away from the first rear side surface.

10. The heat dissipation structure according to any one of claims 1 to 9, wherein the heat dissipation structure further comprises a second frame component and a second elastic member, and the second frame component comprises a second frame and a second connector; and the second frame is configured to accommodate a second insertion module, the second frame comprises a second top surface, a second bottom surface, and a second rear side surface, the second top surface and the second bottom surface are disposed opposite to each other, and the second rear side surface is located between the second top surface and the second bottom surface;
the heat dissipation substrate is located between the first frame component and the second frame component, and the heat dissipation substrate is located below the second bottom surface, and is configured to dissipate heat for the second insertion module by coming into contact with the second bottom surface and/or the second insertion module;
the second connector is located in a cavity of the second frame close to the second rear side surface, the second connector comprises a third connection end and a fourth connection end, the third connection end is electrically connected to the fourth connection end, the fourth connection end is configured to connect to a second cable, and all signals of the second connector are connected to an external signal through the fourth connection end and the second cable;
the second insertion module comprises a second signal end, and when the second signal end is not accurately aligned in a process of being inserted into the third connection end, the second signal end is configured to drive the second connector to float between the second top surface and the second bottom surface; and
the second elastic member is connected to the second top surface, and the second elastic member is configured to: after the second insertion module is inserted into the second frame, press the second insertion module toward the second bottom surface under elastic force.

11. The heat dissipation structure according to claim 10, wherein the heat dissipation structure further comprises a second heat sink; and the second heat sink is disposed on the second top surface, the second top surface comprises a third window, and the second elastic member is configured to: after the second insertion module is inserted into the second frame, press the second insertion module toward the second bottom surface under elastic force through a portion that is of the second heat sink and that is opposite to the third window.

12. The heat dissipation structure according to claim 11, wherein the second heat sink comprises a fourth protrusion part, the fourth protrusion part is inserted into the third window, and a portion of the fourth protrusion part is located in the second frame; and the second elastic member is configured to: after the second insertion module is inserted into the second frame, press the fourth protrusion part toward the second insertion module under elastic force.

13. The heat dissipation structure according to claim 11 or 12, wherein a surface that is of the second heat sink and that is away from the heat dissipation substrate further comprises a second heat dissipation fin, and the second heat dissipation fin extends in a direction from the second bottom surface to the second top surface.

14. The heat dissipation structure according to any one of claims 10 to 13, wherein the second bottom surface comprises a fourth window, the heat dissipation substrate further comprises a fifth protrusion part, the fifth protrusion part is inserted into the fourth window, and at least a portion of the fifth protrusion part is located in the second frame; and the fifth protrusion part is configured to come into contact with the second insertion module.

15. The heat dissipation structure according to any one of claims 10 to 13, wherein a sixth protrusion part is disposed on the second bottom surface, the sixth protrusion part protrudes from the second bottom surface in the direction from the second bottom surface to the second top surface, and the sixth protrusion part is configured to come into contact with the second insertion module.

16. The heat dissipation structure according to any one of claims 10 to 13, wherein the second bottom surface is configured to directly come into contact with the second insertion module.

17. The heat dissipation structure according to any one of claims 10 to 16, wherein an opening of the third connection end comprises a third guiding surface and a fourth guiding surface that are disposed opposite to each other, the third guiding surface is closer to the second top surface than the fourth guiding surface, and a spacing between the third guiding surface and the fourth guiding surface gradually increases in a direction away from the second rear side surface.

18. The heat dissipation structure according to any one of claims 10 to 17, wherein the second frame further comprises a second stop part, the second stop part is located in the second frame, the second stop part is connected to at least one of the second top surface and the second bottom surface, and the second stop part is configured to limit movement of the second connector in the direction away from the second rear side surface.

19. The heat dissipation structure according to any one of claims 10 to 18, wherein the heat dissipation structure comprises a plurality of first frame components, a plurality of first heat sinks, and a plurality of first elastic members, the plurality of first frame components are sequentially arranged in a first direction, the first direction is perpendicular to a direction from the first top surface to the first bottom surface, and the first direction is parallel to the first rear side surface; and
each first heat sink is connected to the first top surface of one first frame under elastic force of one first elastic member, and the first protrusion part of each first heat sink is inserted into the first window of a corresponding first frame; and the first bottom surface of each first frame is in contact with the first heat dissipation surface of the heat dissipation substrate.

20. The heat dissipation structure according to claim 19, wherein two adjacent first frame components are spaced from each other.

21. The heat dissipation structure according to any one of claims 10 to 18, wherein the heat dissipation structure comprises a plurality of first frame components, at least one first heat sink, and at least one first elastic member, the plurality of first frame components are sequentially arranged in a first direction, the first direction is perpendicular to a direction from the first top surface to the first bottom surface, and the first direction is parallel to the first rear side surface; and
one first heat sink is pressed toward the first top surface of each first frame of at least two adjacent first frame components under elastic force of one first elastic member, and one first protrusion part corresponding to the first window of each first frame of the at least two adjacent first frame components is disposed on the one first heat sink; and the first bottom surface of each first frame is in contact with the first heat dissipation surface of the heat dissipation substrate.

22. The heat dissipation structure according to claim 21, wherein a plurality of first frames of the plurality of first frame components are of an integrated structure, or two first frames of two adjacent first frame components are attached to each other.

23. The heat dissipation structure according to any one of claims 19 to 22, wherein the heat dissipation structure comprises a plurality of second frame components, a plurality of second heat sinks, and a plurality of second elastic members, and the plurality of second frame components are sequentially arranged in the first direction; and
each second heat sink is connected to the second top surface of one second frame component under elastic force of one second elastic member, and the fourth protrusion part of each second heat sink is inserted into the third window of a corresponding second frame component.

24. The heat dissipation structure according to any one of claims 19 to 22, wherein the heat dissipation structure comprises a plurality of second frame components, at least one second heat sink, and at least one second elastic member, and the plurality of second frame components are sequentially arranged in the first direction; and
one second heat sink is pressed toward the second top surface of each of at least two adjacent second frame components under elastic force of one second elastic member, and one fourth protrusion part corresponding to the third window of each of the at least two adjacent second frame components is disposed on the one second heat sink.

25. The heat dissipation structure according to claim 24, wherein a plurality of second frames of the plurality of second frame components are of an integrated structure, or two second frames of two adjacent second frame components are attached to each other.

26. The heat dissipation structure according to any one of claims 23 to 25, wherein the plurality of first frame components are disposed in a one-to-one correspondence with the plurality of second frame components.

27. The heat dissipation structure according to any one of claims 10 to 26, wherein the first heat dissipation surface of the heat dissipation substrate further comprises a third heat dissipation fin, the third heat dissipation fin is located on a peripheral side of the first frame component, and the third heat dissipation fin extends in a direction from the second heat dissipation surface to the first heat dissipation surface; and
the second heat dissipation surface of the heat dissipation substrate further comprises a fourth heat dissipation fin, the fourth heat dissipation fin is located on a peripheral side of the second frame component, and the fourth heat dissipation fin extends in a direction from the first heat dissipation surface to the second heat dissipation surface.

28. The heat dissipation structure according to any one of claims 1 to 27, wherein the heat dissipation substrate is a liquid cooling plate.

29. The heat dissipation structure according to any one of claims 10 to 27, wherein the heat dissipation substrate comprises a first substrate, a second substrate, and a fifth heat dissipation fin, the first substrate and the second substrate are disposed opposite to each other, and the fifth heat dissipation fin is located between the first substrate and the second substrate; and
the heat dissipation substrate is located between the first frame component and the second frame component, and the first substrate is located below the first bottom surface of the first frame, and is configured to dissipate heat for the first insertion module by coming into contact with the first bottom surface and/or the first insertion module; and the second substrate is located below the second bottom surface of the second frame, and is configured to dissipate heat for the second insertion module by coming into contact with the second bottom surface and/or the second insertion module.

30. An efficient heat dissipation structure for an insertion module, comprising a first frame component, a first heat sink, a first elastic member, and a fastening substrate, wherein the first frame component comprises a first frame and a first connector;
the first frame is configured to accommodate a first insertion module, the first frame comprises a first top surface, a first bottom surface, and a first rear side surface, the first top surface and the first bottom surface are disposed opposite to each other, and the first rear side surface is located between the first top surface and the first bottom surface;
the first heat sink is disposed on the first top surface;
the fastening substrate is located below the first bottom surface and is configured to support the first frame component;
the first connector is located in a cavity of the first frame close to the first rear side surface, the first connector comprises a first connection end and a second connection end, the first connection end is electrically connected to the second connection end, the second connection end is configured to connect to a first cable, and all signals of the first connector are connected to an external signal through the second connection end and the first cable;
the first insertion module comprises a first signal end, and when the first signal end is not accurately aligned in a process of being inserted into the first connection end, the first signal end is configured to drive the first connector to float between the first top surface and the first bottom surface; and
the first elastic member is connected to the first bottom surface, and the first elastic member is configured to: after the first insertion module is inserted into the first frame, press the first insertion module toward the first top surface under elastic force.

31. The heat dissipation structure according to claim 30, wherein the heat dissipation structure further comprises a second frame component, a second heat sink, and a second elastic member, and the second frame component comprises a second frame and a second connector; and the second frame is configured to accommodate a second insertion module, the second frame comprises a second top surface, a second bottom surface, and a second rear side surface, the second top surface and the second bottom surface are disposed opposite to each other, and the second rear side surface is located between the second top surface and the second bottom surface;
the second heat sink is disposed on the second top surface;
the fastening substrate is located below the second bottom surface and is configured to support the second frame component;
the second connector is located in a cavity of the second frame close to the second rear side surface, the second connector comprises a third connection end and a fourth connection end, the third connection end is electrically connected to the fourth connection end, the fourth connection end is configured to connect to a second cable, and all signals of the second connector are connected to an external signal through the fourth connection end and the second cable;
the second insertion module comprises a second signal end, and when the second signal end is not accurately aligned in a process of being inserted into the third connection end, the second signal end is configured to drive the second connector to float between the second top surface and the second bottom surface; and
the second elastic member is connected to the second bottom surface, and the second elastic member is configured to: after the second insertion module is inserted into the second frame, press the second insertion module toward the second top surface under elastic force.

32. A communication device, comprising a first insertion module and the heat dissipation structure according to any one of claims 1 to 31, wherein the first insertion module is accommodated in the first frame.
